(19) Europäisches Patentamt
European Patent Office
Office européen des brevets

(11) **EP 2 345 903 B1**

(12) **EUROPEAN PATENT SPECIFICATION**

(45) Date of publication and mention
of the grant of the patent:
**19.07.2017 Bulletin 2017/29**

(51) Int Cl.:
*G01R 31/34* *(2006.01)*          *G01R 31/06* *(2006.01)*
*G01R 31/12* *(2006.01)*          *H02K 11/20* *(2016.01)*
*H02K 11/33* *(2016.01)*          *H02K 11/35* *(2016.01)*

(21) Application number: **11162776.6**

(22) Date of filing: **22.10.2004**

(54) **METHOD AND APPARATUS FOR PREDICTING THE RESIDUAL LIFE OF A COIL**

VERFAHREN UND EINRICHTUNG ZUR SCHÄTZUNG DER VERBLEIBENDEN LEBENSDAUER EINER SPULE

PROCÉDÉ ET DISPOSITIF POUR ESTIMER LA DURÉE DE VIE RESTANTE D'UNE BOBINE

(84) Designated Contracting States:
**FR**

(30) Priority: **24.10.2003 JP 2003365317**
**19.12.2003 JP 2003423594**

(43) Date of publication of application:
**20.07.2011 Bulletin 2011/29**

(62) Document number(s) of the earlier application(s) in
accordance with Art. 76 EPC:
**04793169.6 / 1 703 293**

(73) Proprietors:
• **Kabushiki Kaisha Toshiba**
**Minato-ku,**
**Tokyo 105-8001 (JP)**
• **Toshiba Plant Systems & Services Corporation**
**Tokyo 144-8721 (JP)**

(72) Inventors:
• **Inoue, Yoshiyuki**
**Tokyo 105-8001 (JP)**
• **Sekito, Shinobu**
**Tokyo 105-8001 (JP)**
• **Shimada, Hideyuki**
**Tokyo 105-8001 (JP)**
• **Hasegawa, Hiroshi**
**Tokyo 105-8001 (JP)**
• **Koyama, Mitsuhiko**
**Tokyo 105-8001 (JP)**
• **Kaneiwa, Hiroshi**
**Tokyo 105-8001 (JP)**
• **Oono, Shinji**
**Tokyo 105-8001 (JP)**
• **Tonosaki, Nobuyuki**
**Tokyo 105-8001 (JP)**

(74) Representative: **Delumeau, François Guy et al**
**Cabinet Beau de Loménie**
**158, rue de l'Université**
**75340 Paris Cedex 07 (FR)**

(56) References cited:
**EP-A1- 1 503 218      EP-A2- 0 758 158**
**FR-A1- 2 737 015      JP-A- 4 299 051**
**JP-A- 10 177 053**

• **INOUE Y ET AL: "Technology for detecting wet bars in water-cooled stator windings of turbine generators", ELECTRIC MACHINES AND DRIVES CONFERENCE, 2003. IEMDC'03. IEEE INTERNATIONAL JUNE 1-4, 2003, PISCATAWAY, NJ, USA,IEEE, vol. 2, 1 June 2003 (2003-06-01), pages 1337-1343, XP010643523, ISBN: 978-0-7803-7817-9**

## EP 2 345 903 B1

**Description**

Technical Field

The present invention relates to a coil residual life predicting method and apparatus for predicting a residual life of a coil in the case where cooling water leaks from a conductor while the conductor is directly cooled with the cooling water during operation.

Background Art

In a rotating electric machine, as a capacitance is increased, an amount of current flowing through a stator coil (stator winding) increases, and temperature is accordingly increased due to a loss of Joule heat, which hinders stable operation.

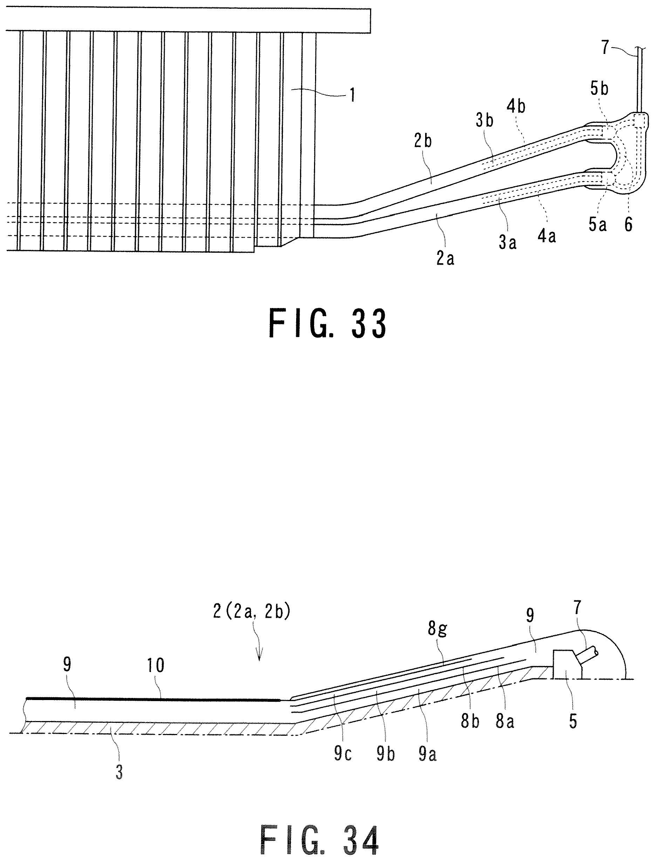

Hence, in recent years, a number of large-capacity rotating electric machines that directly supplies cooling water to a stator coil to cool the coil with the cooling water. Fig. 33 shows an example of the configuration thereof.

In a conventional large-capacity rotating electric machine, a lower coil 2b and an upper coil 2a are inserted through grooves formed in a central portion along a radial direction of a stator core 1 formed in a cylindrical shape.

In the upper coil 2a and the lower coil 2b, hollow-core flat type copper wire is used alone or solid-core flat type copper wire is used as elemental wire in combination with flat wire to form conductors 3a and 3b having a rectangular sectional shape and covered with insulating layers 4a and 4b, respectively.

The upper coil 2a and the lower coil 2b are structured such that clips 5a and 5b are brazed to ends of the conductors 3a and 3b and connected with each other through a hollow connecting conductor 6 to thereby directly cool the conductors 3a and 3b with cooling water, for example, deionized water supplied from an insulating connecting pipe 7.

Incidentally, after the operation of the large-capacity rotating electric machine over many years, a brazed portion between the conductors 3a and 3b and the clips 5a and 5b is deteriorated due to corrosion to form a pore, with the result that cooling water leaks to the insulating layers 4a and 4b to cause breakdown of the coil 2.

The brazed portions between the conductors 3a and 3b and clips 5a and 5b are covered with the insulating layers 4a and 4b, making it impossible to visually observe the breakdown of the coil 2. Thus, up to now, techniques as disclosed in, for example, Japanese Unexamined Patent Application Publication Nos. 9-331656, 9-51658, and 10-177053 have been used as means for checking leakage of the cooling water to the insulating layers 4a and 4b as for the coil 2 where the insulating layers 4a and 4b have no internal electrode. As for the coil where the insulating layers 4a and 4b have an internal electrode, a technique as disclosed in Japanese Unexamined Patent Application Publication No. 2000-126293 has been used.

These techniques take advantage of a phenomenon that a capacitance of the insulating layers 4a and 4b increases due to the leakage of the cooling water. With these techniques, an electrode is provided to a coil, and a capacitance between the conductors 3a and 3b and the electrode is measured. If the measured capacitance value is large, it is determined that the cooling water leaks to the insulating layers 4a and 4b.

Further, these techniques enable simple operation and thus are highly appreciated as means for simply checking leakage of cooling water to an insulating layer and implemented.

Incidentally, in recent large-capacity rotating electric machines, as an insulating structure of a coil, internal electrodes 8a, 8b, and 8g are provided in insulating layers 9, 9a, 9b, and 9c to suppress generation of electric field on the coil surface as shown in Figs. 33 and 34.

Herein, the three-layer internal electrodes 8a, 8b, and 8g are described by way of example, but internal electrodes of two layers or four or more layers may be adopted. Among the three internal electrodes, the innermost internal electrode 8a is referred to as the first internal electrode 8a, the intermediate internal electrode 8b is referred to as the second internal electrode 8b, and the outermost internal electrode 8g is referred to as the third internal electrode 8g, which are arranged in the order from the conductors 3a and 3b of the coil 2 toward the outer edge of the coil.

To describe the insulating structure of the coil applied to the recent large-capacity rotating electric machine, the conductors 3 of the coils 2 (a pair of the upper coil 2a and the lower coil 2b) are covered with the insulating layers 9, 9a to 9c, the insulating layers 9, 9a to 9c are provided with the three electrodes, that is, the first internal electrode 8a, the second internal electrode 8b, and the third internal electrode 8g, the third internal electrode 8g is connected with a low-resistance layer 10 as the outermost layer of a linear portion of the coils 2 (2a and 2b), and the first internal electrode 8a and the second internal electrode 8b divide a capacitance of the insulating layers 9a, 9b, and 9c to suppress generation of electric field at the outer surface of the insulating layer in a coil end portion.

Further, ends of the coil end portion are provided with the clips 5 (5a and 5b) including the insulating connecting pipe 7 for directly cooling the conductors 3 (3a and 3b) with cooling water.

In the large-capacity rotating electric machine having such coil insulating structure, if the techniques as disclosed in the above publications are applied, although it can be readily determined whether or not cooling water infiltrates into the insulating layer, it is difficult to grasp a breakdown voltage at the current time (measurement time), and in addition, to grasp a residual life that means when the service life of the machine expires.

In particular, along with recent tendencies to increase a capacity of the electric machine, a residual life predicting technique becomes more importance because of a longer preparation and implementation period for maintenance, reform, or the like.

The invention related to the residual life predicting technique is disclosed in, for example, Japanese Unexamined Patent Application Publication No. 9-93873.

The disclosed technique cuts a brazed portion between the clip at the end of the stator coil and the conductor for the sampling purpose and then examined to determine when cooling water starts leaking and predict a residual life based on data on a decreasing rate of a breakdown voltage which would drop after the leakage.

However, this technique requires removal of an insulating portion of the connection portion between coils. As a result, some problems remain to be solved, that is, it is indispensable to cut and examine the coil end portion, and recovery thereof requires a lot of time and cost.

The document by Inoue Y et al., entitled "Technology for detecting wet bars in water-cooled stator windings of turbine generators", Electric Machines and Drives Conference, Inc. 2003, describes a capacitance measurement method for detecting wet bars in water-cooled turbine generators and introduces a method that can be applied for detecting wet bars of any design.

Thus, there is a demand for a technique capable of predicting a residual life of a coil in a shorter time at a lower cost without damaging parts.

Disclosure of The Invention

The present invention has been accomplished in view of the above matters, and accordingly, an object of the present invention is to provide a coil residual life predicting method and apparatus capable of estimating a breakdown voltage of an insulating layer and predicting a residual life based on the estimated breakdown voltage without damaging the layer and removing a coil involving leakage from a conductor to an insulating layer.

In order to attain the above object, a coil residual life predicting method according to the present invention comprises the process steps as recited in claim 1. In general, the method includes: a first step of checking whether or not cooling water from a conductor leaks to an insulating layer, and executing measurement necessary for estimating a breakdown voltage of a coil if the conductor cooling water leaks to the insulating layer to estimate a breakdown voltage of a coil; a second step of determining a temperature of the coil and an applied voltage based on future operating conditions of the coil to determine a decreasing rate of the breakdown voltage of the coil based on at least one of the temperature of the coil and the applied voltage; and a third step of extrapolating data obtained in the first step and the second step to determine a period necessary for the breakdown voltage to drop down to a voltage necessary for operating the coil.

Further, in order to attain the above object, a coil residual life predicting method according to the invention includes: a first step of checking whether or not cooling water from a conductor leaks to an insulating layer, and executing measurement necessary for estimating a breakdown voltage of a coil plural times with time if the conductor cooling water leaks to the insulating layer to estimate a breakdown voltage of a coil, and estimating a breakdown voltage of a coil each time the measurement is executed; a second step of drawing and extrapolating a curve representing a change of the breakdown voltage with time to predict a future decreasing tendency of the breakdown voltage; and a third step of determining a period necessary for the breakdown voltage to drop down to a voltage necessary for operating the coil based on the curve representing the change with time. Furthermore, in the coil residual life predicting method according to the invention, the first step of estimating the breakdown voltage of the coil includes applying an alternative voltage to a conductor of the coil, measuring an internal electrode potential at an outer surface of an insulating layer on an internal electrode, and calculating a breakdown voltage corresponding to the measured internal electrode potential based on a previously created breakdown voltage-internal electrode potential characteristic diagram.

Further, the first step of estimating the breakdown voltage of the coil may include applying an alternative voltage to a conductor of the coil, measuring an internal electrode potential at an outer surface of an insulating layer on an internal electrode, determining a ratio between the measured internal electrode potential and an initial value of the internal electrode potential or an internal electrode potential of the coil determined not to suffer leakage of the conductor cooling water into the insulating layer, and calculating a breakdown voltage corresponding to the determined ratio based on a previously created breakdown voltage-ratio-between-internal electrode-potential-and-initial-value characteristic diagram.

Further, the first step of estimating the breakdown voltage of the coil may include applying an alternative voltage to a conductor of the coil, measuring an internal electrode potential at an outer surface of an insulating layer on an internal electrode, determining a ratio between adjacent internal electrode potentials, and calculating a breakdown voltage corresponding to the determined ratio based on a previously created breakdown voltage-ratio-between-adjacent-internal electrode-potentials characteristic diagram.

Further, the first step of estimating the breakdown voltage of the coil may include attaching a measurement electrode to an outer surface of an insulating layer including the internal electrode and an outer surface of an insulating layer in a portion apart from the internal electrode, measuring dielectric characteristics between the measurement electrode and the internal electrode and between the measurement electrode and a conductor in the portion apart from the internal electrode, and calculating a breakdown voltage corresponding to the determined dielectric characteristics based on a previously created breakdown voltage-dielectric characteristic diagram.

Further, the first step of estimating the breakdown voltage of the coil may include attaching a measurement electrode to an outer surface of an insulating layer including the internal electrode and an outer surface of an insulating layer in a portion apart from the internal electrode, measuring dielectric characteristics between the measurement electrode and the internal electrode and between the measurement electrode and a conductor in the portion apart from the internal electrode, determining a ratio of dielectric characteristics at two frequencies, and calculating a breakdown voltage corresponding to the determined ratio based on a previously created diagram showing a breakdown voltage-dielectric characteristic change rate with frequency.

Further, the first step of estimating the breakdown voltage of the coil may include determining an appropriate breakdown voltage value if two breakdown voltage values are obtained for one internal electrode potential upon calculating the breakdown voltage based on one of a breakdown voltage-internal electrode potential characteristic diagram, a breakdown voltage-ratio-between-internal electrode-potential-and-initial-value characteristic diagram, and a breakdown voltage-ratio-between-adjacent-internal electrode-potentials characteristic diagram, in combination with a breakdown voltage-dielectric characteristic diagram.

Further, the first step of estimating the breakdown voltage of the coil may include determining an appropriate breakdown voltage value if two breakdown voltage values are obtained for one internal electrode potential upon calculating the breakdown voltage based on one of a breakdown voltage-internal electrode potential characteristic diagram, a breakdown voltage-ratio-between-internal electrode-potential-and-initial-value characteristic diagram, and a breakdown voltage-ratio-between-adjacent-internal electrode-potentials characteristic diagram, based on a change of a previously measured potential.

Further, the second step of estimating a decreasing rate of the breakdown voltage of the coil may include: supplying and circulating water that is kept at a constant pressure and is set at two or more temperatures through a plurality of conductors of a plurality of coils that have a hole of a predetermined size in hollow elemental wire near a clip and are not subjected to leakage of water, or of coils determined to suffer leakage of the conductor cooling water into the insulating layer during operation; executing a dielectric test at a plurality of positions different in the degree at which the cooling water infiltrates, at the two or more temperatures; creating a breakdown voltage-hot water circulation period diagram based on the determined breakdown voltage and hot water circulation period and determining a decreasing rate of the breakdown voltage based on the breakdown voltage-hot water circulation period diagram; creating an Arrhenius plot representative of a relation with the temperature of circulating water based on the determined decreasing rate of the breakdown voltage; and calculating a decreasing rate of the breakdown voltage corresponding to a predetermined temperature of the circulating water from the Arrhenius plot.

Further, the second step of estimating a decreasing rate of the breakdown voltage of the coil may include: a step A of supplying and circulating water that is kept at a constant pressure and is set at one temperature through a plurality of conductors of a plurality of coils that have a hole of a predetermined size in hollow elemental wire near a clip and are not subjected to leakage of water, or of coils determined to suffer leakage of the conductor cooling water into the insulating layer during operation, executing a dielectric test at a plurality of hot water circulation points different in the degree at which the cooling water infiltrates and then disassembling the coil to sample the insulating layer and measure a content Ga of a chemically specific group S in a resin of the insulating layer which changes due to hydrolysis, and determining a change rate Ka of the breakdown voltage relative to the content Ga, and a change speed Ua of the content Ga with respect to a hot water circulation period; a step B of bringing a test piece of an insulating layer cut out from a normal coil into contact with hot water set to two or more temperatures for a predetermined period and then removing the test piece, and measuring a content Gb of a specific group S in the test piece similar to the group in the step A to determine a change speed Ub of the content Gb with respect to a hot water contact period for each of the temperatures of the hot water; and a step C of drawing, in a graph where one axis represents the logarithm of the change speed Ua of the content Ga of the specific group S in the insulating layer obtained in the step A and the change speed Ub of the content Gb of the specific group S at the plurality of temperatures obtained in the step B, and the other axis represents a temperature, a line passing one point of the former and extending in parallel to the regression line of the latter to obtain a change speed Uc of a content of the specific group S at a predetermined temperature, and a decreasing rate of the breakdown voltage at the predetermined temperature is obtained based on the product of the change rate Ka of the breakdown voltage obtained in the step A by the change rate Uc of the content of the specific group S at the predetermined temperature obtained in the step C.

Further, the second step of estimating a decreasing rate of the breakdown voltage of the coil may include: a

4

step (step A) of supplying and circulating water that is kept at a constant pressure and is set at one temperature through a plurality of conductors of a plurality of coils that have a hole of a predetermined size in hollow elemental wire near a clip and are not subjected to leakage of water, or of coils determined to suffer leakage of the conductor cooling water into the insulating layer during operation, executing a dielectric test at a plurality of hot water circulation points different in the degree at which the cooling water infiltrates and then disassembling the coil to sample the insulating layer and measure a content $Ga$ of a chemically specific group S in a resin of the insulating layer which changes due to hydrolysis and a content $Ga_0$ of the specific group S in a normal insulating layer (initial value of a content of the specific group S) to determine a change amount $\Delta Ga$ ($|Ga - Ga_0|$) from an initial value of the content of the specific group S, and determining a change rate $Ka$ of the breakdown voltage relative to the change amount $\Delta Ga$, and a change speed $Ua$ of the change amount $\Delta Ga$ with respect to a hot water circulation period; a step (step B) of bringing a test piece of an insulating layer cut out from a normal coil into contact with hot water set to two or more temperatures for a predetermined period and then removing the test piece, and measuring a change amount $\Delta Gb$ from an initial value of a content of the specific group S in the test piece similar to the group in the step A to determine a change speed $Ub$ of the change amount $\Delta Gb$ with respect to a hot water contact period for each of the temperatures of the hot water; and a step (step C) of drawing, in a graph where one axis represents the logarithm of the change speed $Ua$ of the change amount $\Delta Ga$ from the initial value of the content of the specific group S in the insulating layer obtained in the step A and the change speed $Ub$ of the change amount $\Delta Gb$ from the initial value of the content of the specific group S at the plurality of temperatures obtained in the step B, and the other axis represents a temperature, a line passing one point of the former and extending in parallel to the regression line of the latter to obtain a change speed $Uc$ of a change amount from an initial value of a content of the specific group S at a predetermined temperature, and a decreasing rate of the breakdown voltage at the predetermined temperature is obtained based on the product of the change rate $Ka$ of the breakdown voltage obtained in the step A by the change speed $Uc$ of the change amount from the initial value of the content of the specific group S at the predetermined temperature obtained in the step C.

Further, the second step of estimating a decreasing rate of the breakdown voltage of the coil may include: supplying and circulating hot water that is kept at a constant pressure and is set at a predetermined temperature through a plurality of conductors of a plurality of coils that have a hole of a predetermined size in hollow elemental wire near a clip and are not subjected to leakage of water, or of coils determined to suffer leakage of the conductor cooling water into the insulating layer during operation under conditions that linear portions of a part of the plurality of coils are applied with a predetermined voltage and the rest is not applied with a voltage, executing a dielectric test at a plurality of points different in the degree at which the water infiltrates; creasing a breakdown voltage-hot water circulation period diagram based on the determined breakdown voltage and hot water circulation period; and determining decreasing rates of the breakdown voltage for the coils applied with the voltage and the coils not applied with the voltage during the hot water circulation based on the breakdown voltage-hot water circulation period diagram and determining an increase of the decreasing rate of the breakdown voltage due to the voltage application based on a ratio between the decreasing rates.

Further, the second step of estimating a decreasing rate of the breakdown voltage of the coil may include: periodically measuring an internal electrode potential from an outer surface of an insulating layer on an internal electrode for a coil of an actually operating coil; measuring dielectric characteristics between a measurement electrode provided on the outer surface of the insulating layer of the coil in the portion apart from the internal electrode and the conductor to grasp a timing at which cooling water starts leaking into the insulating layer based on a change in measurement value; taking the coil off after the elapse of a predetermined period; and determining a difference between an estimated value of the breakdown voltage in the case where the cooling water does not leak and an actual breakdown voltage based on an operation period from the timing at which the cooling water starts leaking to the insulating layer to removal of the coil, and a decreasing rate of a breakdown voltage of the coil at the timing at which the cooling water starts leaking to the insulating layer.

Further, the first step of estimating the breakdown voltage of the coil may include creating a breakdown voltage-internal electrode potential characteristic diagram, a breakdown voltage-ratio-between-internal electrode-potential-and-initial-value characteristic diagram, a breakdown voltage-ratio-between-adjacent-internal electrode-potentials characteristic diagram, a breakdown voltage-adjacent-electrodes characteristic diagram, and a diagram a breakdown voltage-dielectric characteristic change rate with frequency based on an internal electrode potential measured at an outer surface of an insulating layer on an internal electrode just before a dielectric test for a plurality of coils suffering leakage of cooling water, dielectric characteristics between a measurement electrode placed on the outer surface of the insulating layer and a conductor and between the measurement electrode and the internal electrode, and a breakdown voltage measured after the measurements; and estimating a breakdown voltage based on the created diagrams at subsequent measurements.

In order to attain the above object, a coil residual life predicting apparatus according to the invention comprises the features as recited in claim 9. The apparatus includes: a non-contact surface electrometer for measuring a potential of an internal electrode provided in an insulating layer that covers a coil; and a dielectric characteristic measuring apparatus for measuring dielectric characteristics between at least one of the internal electrode and a conductor and a measurement electrode attached to an outer surface of the insulating layer of the coil to predict a residual life based on a breakdown voltage estimated based on the measured potential, wherein upon attaching the measurement electrode to the insulating layer, a probe of the non-contact surface electrometer is moved along the coil, and the measurement electrode is attached to the surface of the insulating layer at a position where a stable surface potential is detected.

Further, a coil residual life predicting apparatus includes: a non-contact surface electrometer for measuring a potential of an internal electrode provided in an insulating layer that covers a coil; and a dielectric characteristic measuring apparatus for measuring dielectric characteristics between at least one of the internal electrode and a conductor and a measurement electrode attached to an outer surface of the insulating layer of the coil to predict a residual life based on a breakdown voltage estimated based on the measured potential and the dielectric characteristics, wherein the dielectric characteristic measuring apparatus has a high-pressure terminal connected with at least one of an output terminal and a neutral terminal of a device to be measured and has a low-pressure terminal connected with the measurement electrode attached to the outer surface of the insulating layer of the coil.

Further, a coil residual life predicting apparatus includes: a non-contact surface electrometer for measuring a potential of an internal electrode provided in an insulating layer that covers a coil; and a dielectric characteristic measuring apparatus for measuring dielectric characteristics between at least one of the internal electrode and a conductor and a measurement electrode attached to an outer surface of the insulating layer of the coil to predict a residual life based on a breakdown voltage estimated based on the measured potential and the dielectric characteristics, wherein the dielectric characteristic measuring apparatus has a high-pressure terminal connected with at least one of a casing for accommodating the coil and an iron core and has a low-pressure terminal connected with the measurement electrode attached to the outer surface of the insulating layer of the coil. The coil residual life predicting method is implemented through a first step of checking whether or not cooling water from a conductor leaks to an insulating layer, and executing measurement necessary for estimating a breakdown voltage of a coil if the conductor cooling water leaks to the insulating layer to non-destructively estimate a breakdown voltage of a coil; a second step of non-destructively estimating a curve showing a future decrease in coil breakdown voltage; and a third step of extrapolating data obtained in the first and second steps to determine a period necessary for the breakdown voltage to drop down to a voltage necessary for operating the coil. Thus, the residual life of the coil can be non-destructively, simply, and readily estimated, making it possible to speedily respond to quick exchange and maintenance of a coil.

In addition, according to the coil residual life predicting apparatus the position of the internal electrode in the insulating layer is detected from the outer surface of the insulating layer, and the electrode is set in an appropriate position of the outer surface of the insulating layer, and also, the dielectric characteristic measuring apparatus and terminals thereof are connected to an appropriate portion, enabling a high measurement accuracy of the dielectric characteristics and highly accurate prediction of the coil residual life.

Other properties and features of the present invention would be apparent upon reading the following description taken in conjunction with the accompanying drawings.

Brief Description of The Drawings

Fig. 1 is an illustrated block diagram showing a coil residual life predicting method according to an embodiment of the present invention.

Fig. 2 is a chart showing a relation between a operating period and a breakdown voltage of a coil applied to a coil residual life predicting method according to a first embodiment of the present invention.

Fig. 3 is a chart showing a relation between a operating period and a breakdown voltage of a coil applied to a coil residual life predicting method according to a second embodiment of the present invention.

Fig. 4 is a conceptual view showing a breakdown voltage measuring apparatus used for estimating a breakdown voltage of a coil with the coil residual life predicting method according to the present invention.

Fig. 5 is a sectional view taken along the line V-V of the coil of Fig. 4.

Fig. 6 shows an electrical equivalent circuit for calculating a potential of an internal electrode of Fig. 4.

Fig. 7 is a characteristic diagram showing a breakdown voltage-internal electrode potential characteristic in the case of estimating a breakdown voltage in a first step of the coil residual life predicting method according to the first embodiment of the present invention.

Fig. 8 is a characteristic diagram showing another breakdown voltage-internal electrode potential characteristic in the case of estimating a breakdown voltage in the first step of the coil residual life predicting method according to the first embodiment of the present invention.

Fig. 9 is a breakdown voltage-ratio between internal electrode potentials and initial values characteristic diagram in the case of estimating a breakdown voltage in the first step of the coil residual life predicting method according to the second embodiment of the present invention.

Fig. 10 is a characteristic diagram showing another initial value ratio between a breakdown voltage and internal electrode potential in the case of estimating a breakdown voltage in the first step of the coil residual life predicting method according to the second embodiment of the present invention.

Fig. 11 is a breakdown voltage-ratio between internal electrode potentials and initial values characteristic diagram in the case of estimating a breakdown voltage in the first step of a coil residual life predicting method according to a third embodiment of the present invention.

Fig. 12 is a breakdown voltage-ratio between internal electrode potentials and initial values characteristic diagram in the case of estimating a breakdown voltage in the first step of a coil residual life predicting method according to a fourth embodiment of the present invention.

Fig. 13 is a frequency characteristic of a capacitance of an insulating layer used for estimating a breakdown voltage in the first step of a coil residual life predicting method according to a fifth embodiment of the present invention.

Fig. 14 is a frequency characteristic of a capacitance of an insulating layer used for estimating a breakdown voltage in the first step of a coil residual life predicting method according to the fifth embodiment of the present invention.

Fig. 15 shows a ratio among three dielectric characteristics of an insulating layer at 1 kHz and 10 kHz and how much leaked water of conductor cooling water infiltrates into the insulating layer in the case of estimating a breakdown voltage in the first step of the coil residual life predicting method according to the fifth embodiment of the present invention.

Fig. 16 is a chart showing a frequency change rate of a breakdown voltage-dielectric characteristic of a coil including two internal electrodes in the case of estimating a breakdown voltage in the first step of the coil residual life predicting method according to the fifth embodiment of the present invention.

Fig. 17 is a characteristic diagram showing a breakdown voltage-internal electrode potential characteristic in the case of estimating a breakdown voltage in the first step of a coil residual life predicting method according to a sixth embodiment of the present invention.

Fig. 18 is a chart showing a positive tangent line of a breakdown voltage-dielectric characteristic in the case of estimating a breakdown voltage in the first step of the coil residual life predicting method according to the sixth embodiment of the present invention.

Fig. 19 is a characteristic diagram showing a breakdown voltage-internal electrode potential characteristic in the case of estimating a breakdown voltage in the first step of a coil residual life predicting method according to a seventh embodiment of the present invention.

Fig. 20 is a chart showing a relation between a period for circulating hot water in a coil and a breakdown voltage in the case of determining a decreasing speed of the breakdown voltage in a second step of the coil residual life predicting method according to the first embodiment of the present invention.

Fig. 21 is a chart showing a relation between a period for circulating hot water in a coil and a breakdown voltage in the case of determining a decreasing speed of the breakdown voltage in the second step of the coil residual life predicting method according to the first embodiment of the present invention.

Fig. 22 is a chart showing a relation between a change from an initial value of ester group content in an insulating layer and a degradation period in the case of determining a decreasing speed of the breakdown voltage in a second step of the coil residual life predicting method according to the second embodiment of the present invention.

Fig. 23 is a chart showing a relation between a change from an initial value of ester group content in an insulating layer and a degradation period in the case of determining a decreasing speed of the breakdown voltage in the second step of the coil residual life predicting method according to the second embodiment of the present invention.

Fig. 24 is a chart showing a relation between a change rate of ester group content in an insulating layer and a temperature in the case of determining a decreasing speed of the breakdown voltage in the second step of the coil residual life predicting method according to the second embodiment of the present invention.

Fig. 25 is a chart showing a running period-breakdown voltage characteristic of a coil in the case of determining a decreasing speed of the breakdown voltage in the second step of a coil residual life predicting method according to a third embodiment of the present invention.

Fig. 26 is a conceptual view showing a coil residual life predicting method according to a first embodiment of the present invention.

Fig. 27 is a conceptual view showing a coil residual life predicting method according to a second embodiment of the present invention.

Fig. 28 is a conceptual view showing a coil residual life predicting method according to a third embodiment of the present invention.

Fig. 29 is a conceptual view showing a measurement electrode applied to the coil residual life predicting method according to the present invention.

Fig. 30 is a front view of the measurement electrode taken along the line XXX-XXX of Fig. 29.

Fig. 31 is a conceptual view showing another measurement electrode applied to the coil residual life predicting method according to the present invention.

Fig. 32 is a front view of the measurement electrode taken along the line XXXII-XXXII of Fig. 31.

Fig. 33 is a conceptual view of a part of a stator coil in a conventional generator.

Fig. 34 is a conceptual view of a part of an end portion of a coil provided with an internal electrode in an insulating layer of the conventional generator.

## Best Mode for Carrying Out The Invention

Hereinafter, embodiments of a coil residual life predicting method and apparatus according to the present invention will be described with reference to the accompanying drawings and numerals and symbols assigned to illustrated components.

Incidentally, the embodiments of the present invention will be described taking a stator coil of a large-capacity turbine generator as an example, but the present invention is not limited to the example and is applicable to any other possible direct water-cooled coil provided with an internal electrode in an insulating layer.

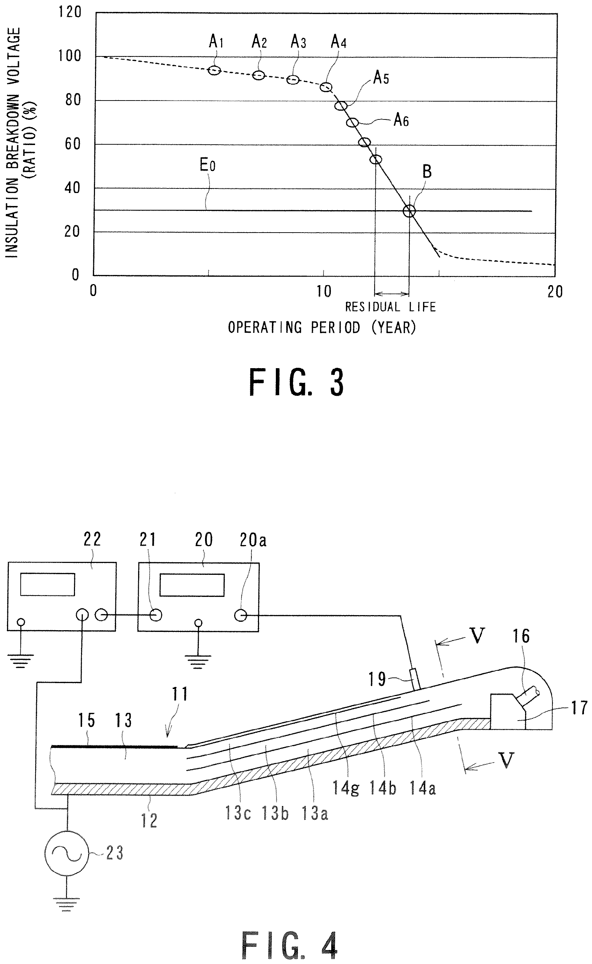

Prior to a description about embodiments of the coil residual life predicting method of the present invention, an insulating structure of a coil is first explained with reference to Figs. 4 to 6.

As the insulating structure of a coil applied to the coil residual life predicting method of the present invention, a conductor 12 of a coil 11 including an upper coil and a lower coil is covered with insulating layers 13 (first insulating layer 13a, 13b, and 13c), a first internal electrode 14a, a second internal electrode 14b, and a third internal electrode 14g are provided in the insulating layers 13 (first insulating layer 13a, the second insulating layer 13b, and the third insulating layer 13c), and the outermost third internal electrode 14g is connected with a low-resistance layer 15 of the coil 11 while a clip 17 including an insulating connecting pipe 16 for supplying cooling water to the conductor 12 at the end of the coil 11 is provided.

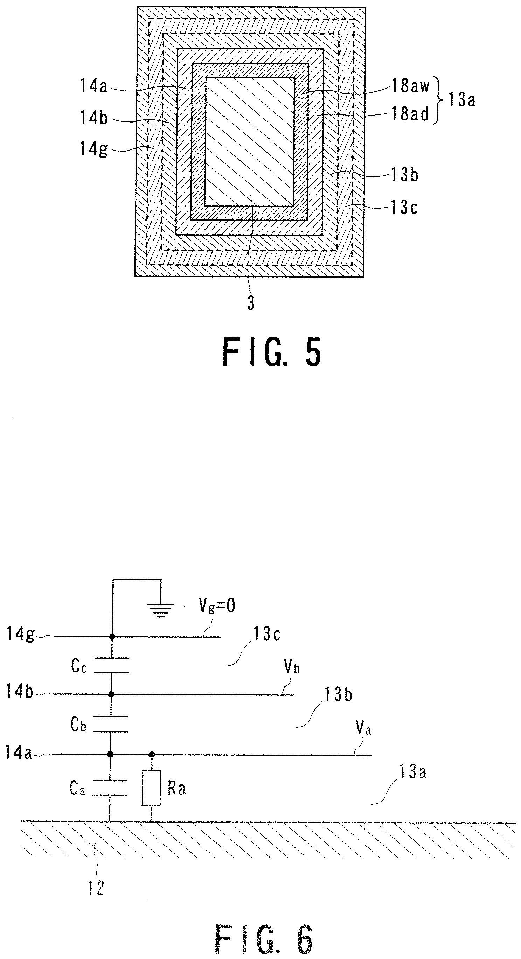

Further, as the insulating structure of the coil applied to the coil residual life predicting method of this embodiment method of the present invention, as shown in Figs. 4 and 5, a first insulating layer 13a, a second insulating layer 13b, and a third insulating layer 13g are provided around the conductor 12 at the central position, between the first internal electrode 14a, the second internal electrode 14b, and the third internal electrode 14g in the order from an inner edge to an outer edge. If the cooling water leaks into the insulating layers, the water infiltrates from the innermost insulating layer to the outer layer. Assuming that the cooling water infiltrates halfway through the insulating layer 13a, the first insulating layer 13a is divided into a cooling water infiltration regain 18a and a dry region 18b not impregnated with the cooling water.

The outermost third internal electrode 14g is grounded to an iron core (not shown) through the low-resistance layer 15. Further, the first internal electrode 14a and the second internal electrode 14g provided between the third internal electrode 14g and the conductor 12 are electrodes having floating potentials and having end portions shifted from each other. Their potentials are determined based on a divided voltage of a capacitance.

In addition, an internal electrode potential measuring apparatus for measuring a potential of an internal electrode of a coil includes a potential measuring probe 19 that is moved to and fro on the outer surface of the coil 11 to determine positions of the first internal electrode 14a, the second internal electrode 14b, and the third internal electrode 14g and measuring a potential of the internal electrodes 14a and 14b, a non-contact surface electrometer 20 connected with a probe connecting terminal 20 through a lead line from the potential measuring probe 19, and a voltage measuring apparatus 22 such as an AC voltmeter or oscilloscope connected from a waveform output terminal 21 of the non-contact surface electrometer 20 through a lead line. The voltage measuring apparatus 22 reads an alternating voltage applied to the conductor 12 from an AC power supply 23 and a potential output from the non-contact surface electrometer 20. The infiltration of the cooling water is detected based on the phenomenon that the internal electrode potential increases if the conductor cooling water infiltrates into any one of the first insulating layer 13a, the second insulating layer 13b, and the third insulating layer 13g.

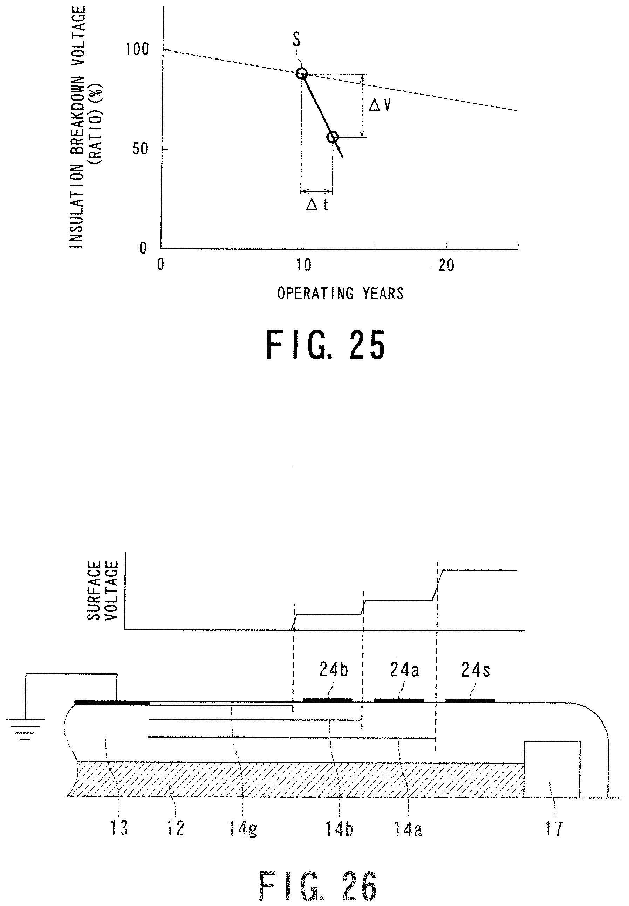

Further, when a measurement electrode is attached to the coil surface to measure dielectric characteristics between the measurement electrode, the first internal electrode 14a, and the second internal electrode 14b and the conductor 12, the alternating voltage is applied to the coil conductor to measure a surface potential of the insulating layers 13 along the axial direction as shown in Fig. 26 and determine a position of the internal electrode to arrange measurement electrodes 24a, 24b, and 24s in appropriate positions, making it possible to measure dielectric characteristics with almost no error.

Incidentally, the alternating voltage applied to the conductor 13 from the AC power supply 23 is sine wave but may be a rectangular or triangular wave. In addition, a frequency of the alternating voltage is preferably a low frequency, for example, 100 Hz or lower in consideration of moisture absorption accompanying the leakage of the conductor cooling water to the first insulating layer 13a, the second insulating layer 13b, and the third insulating layer 13c.

Fig. 6 shows an equivalent circuit for measuring potentials of the first internal electrode 14a, the second internal electrode 14b, and the third internal electrode 14g if leaked water of the conductor cooling water infiltrates in the order from the first insulating layer 13a to the third insulating layer 13c.

In Fig. 6, a capacitance defined between the conductor 12 and the first internal electrode 14a is represented by Ca, a capacitance defined between the conductor 12 and the second internal electrode 14b is represented by Cb, and a capacitance defined between the conductor 12 and the third internal electrode 14g is represented by Cc.

Incidentally, if the infiltration of the cooling water stops within the insulating layer 13a, an equivalent resistor Ra that simulates a dielectric loss of the first insulating layer 13a is provided between the conductor 12 and the internal electrode 14a.

In such an equivalent circuit, if no conductor cooling water infiltrates into the first insulating layer 13a, the second insulating layer 13b, and the third insulating layer 13c, potentials of the internal electrodes 14a and 14b are determined based on a voltage obtained by dividing an applied voltage E with the capacitances Ca, Cb, and Cc.

A potential Va of the first internal electrode 14a and a potential Vb of the second internal electrode 14b are represented by the following expression:

[Expression 1]

$$Va = \{(1/Cb + 1/Cc)/(1/Ca + 1/Cb + 1/Cc)\} \times E \ldots (1)$$

$$Vb = \{1/Cc/(1/Ca + 1/Cb + 1/Cc)\} \times E \ldots (2)$$

If the conductor cooling water leaks to the first insulating layer 13a, a dielectric constant of the cooling water is too large (a dielectric constant of a dry insulating layer is about 4.5 in comparison with a dielectric constant of the cooling water of about 80), so the capacitance Ca of the first insulating layer 13a impregnated with the leaked conductor cooling water increases. Further, a conductivity of the leaked conductor cooling water is much lower than that of the insulating layer, so that a dielectric loss considerably increases. In order to simulate the dielectric loss, the equivalent resistor Ra is provided between the conductor 12 and the first internal electrode 14a.

Further, parallel resistance is necessary for the capacitances Cb and Cc but is omitted since the resistance is sufficiently high if no conductor cooling water leaks.

If the capacitance Ca = 1200 pF, the capacitance Cb = 2000 pF, and the capacitance Cc = 3000 pF, and the applied voltage E = 100 Vrms (50 Hz AC voltage), the potential Va equals 50.0 V based on Expression (1) if the conductor cooling water does not leak to the first insulating layer 13a.

Next, if the conductor cooling water leaks to the first insulating layer 13a, the capacitance Ca shows a three-fold increase, more specifically, the capacitance Ca increases to 3600 pF, and in addition, the dielectric loss increases, and the dielectric tangent ($\tan\delta$) increases to 0.2 (in normal cases, generally about 0.01 or less), the potential Va of the first internal electrode 14a is calculated (calculating expression is complicated and thus omitted) and equals 75.6 V, which value is 51% higher than that of the normal one.

Table 1 summarizes the above values and a potential Vb of the second internal electrode 14b that is calculated based on Expression (2).

Table 1

| Coil state | Potential Va (V) of first internal electrode a | Potential Vb (V) of second internal electrode b | Vb/Va |
| --- | --- | --- | --- |
| Normal | 50.0 | 20.0 | 0.4 |
| Cooling water infiltration | 75.6 | 30.2 | 0.4 |
| V (cooling water infiltration)/V (normal) | 1.51 | 1.51 | - |

As apparent from Table 1, the potential of the second internal electrode 14b is also increased by 51% due to the leakage of the conductor cooling water.

In this way, if the conductor cooling water leaks, the potential of the internal electrode increases and at the same time, the breakdown voltage drops.

Accordingly, a change in potential of the internal electrode correlates with the breakdown voltage. Thus, if this correlation is grasped beforehand, the breakdown voltage would be estimated based on the potential of the internal electrode.

Now, a description is give of a coil residual life predicting method for predicting a coil residual life in the case where the cooling water from the conductor leaks to the insulating layer by use of the coil insulating structure and the internal electrode potential measuring apparatus as shown in Figs. 4 to 6 according to an embodiment of the present invention.

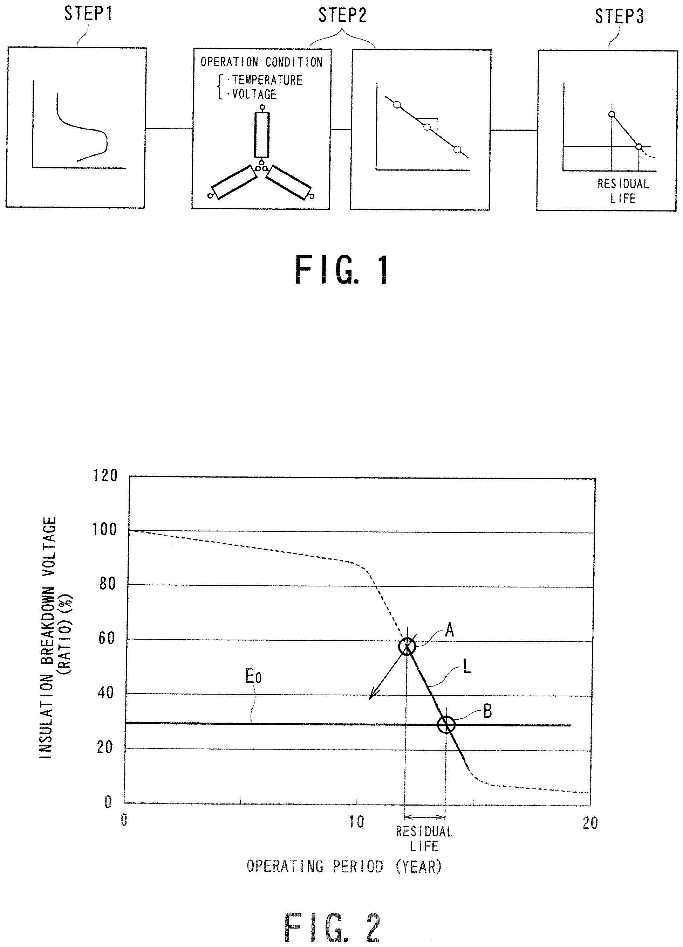

Fig. 1 is a block diagram illustrating the coil residual life predicting method according to the embodiment of the present invention.

The coil residual life predicting method of this embodiment includes a first step (step 1) of determining whether or not the cooling water from the conductor leaks to the insulating layer, and estimating a coil breakdown voltage if the conductor cooling water leaks to the insulating layer, a second step (step 2) of a decreasing rate of the coil breakdown voltage due to at least one of a coil temperature predicted from running conditions of the coil and the applied voltage, and a third step (step 3) of extrapolating data of the first and second steps to determine a period necessary for the breakdown voltage to decrease down to a level necessary for operating a coil.

The coil residual life predicting method of this embodiment including the above steps first determines whether or not the cooling water leaks from the conductor to the insulating layer by measuring a potential of the internal electrode through a surface potential measuring probe and estimates, if the conductor cooling water leaks, the breakdown voltage of the coil damped with the leaked conductor cooling water based on a predetermined chart showing a relation between the internal electrode potential and the breakdown voltage in the first step (specific example of step 1 is described below) to plot the estimated value to a point A on Fig. 2.

Next, in the second step, an applied voltage is determined based on the coil temperature estimated from the future running conditions of the coil and the coil connecting position. Next, the decreasing rate of the breakdown voltage under the running conditions of the coil is determined.

Finally, in the third step, a line L indicative of the decreasing rate of the breakdown voltage determined in the second step is drawn (extrapolated) so as to pass the point A of Fig. 2 to determine a period necessary for decreasing the voltage down to a voltage $E_0$ necessary for operating the coil, that is, a time point B at which the service life expires. Then, a period from a current time (measurement time) to the time point B is estimated as a residual life.

Further, the coil residual life predicting method of this embodiment estimates the breakdown voltage of the coil suffering the leakage of the conductor cooling water to calculate a service life based on one of the estimated data. However, the present invention is not limited to this example. For example, as shown in Fig. 3, in the first step, the breakdown voltage of the coil suffering the leakage of the cooling water may be determined periodically as $A_1$, $A_2$, ..., $A_6$, ..., and in the second step, a curve indicating a breakdown voltage change with time is drawn and further extrapolated, and then in the third step, the time point B on the curve at which the voltage is decreased down to the voltage $E_0$ necessary for operating the coil may be determined to predict a residual life of the coil.

As described above, the coil residual life predicting method of this embodiment estimates the breakdown voltage in the first step (step 1), determines the decreasing rate of the breakdown voltage in the second step (step 2), and extrapolates data obtained in the first and second steps to predict a residual life, that is, a period necessary for the breakdown voltage to decrease down to the level necessary for operating the coil in the third step (step 3). Hence, the coil residual life can be simply and easily predicted without damaging any component.

Next, the first step (step 1) and the second step (step 2) of the coil residual life predicting method of the present invention as shown in Fig. 1 are described in this order.

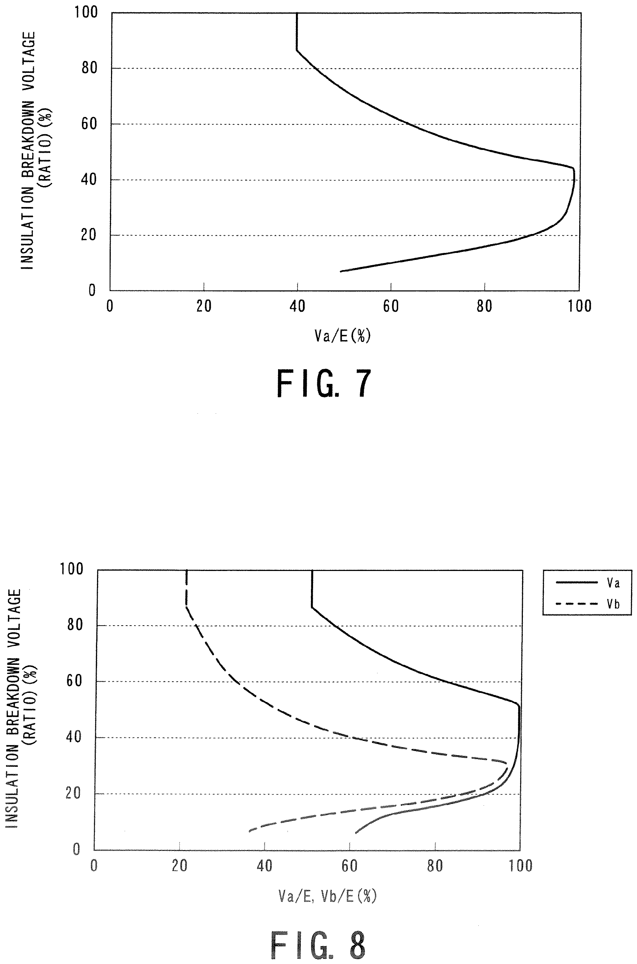

Figs. 7 and 8 are characteristic diagrams showing a breakdown voltage-internal electrode potential characteristic in the case of estimating a breakdown voltage in the first step (step 1) of the coil residual life predicting method according to the first embodiment of the present invention.

Further, Fig. 7 is a characteristic diagram showing a breakdown voltage-internal electrode potential characteristic in the case of providing the insulating layer with two (two-layer) internal electrodes. Fig. 8 is a characteristic diagram showing a breakdown voltage-internal electrode potential characteristic in the case of providing the insulating layer with three (three-layer) internal electrodes.

In Figs. 7 and 8, an initial value of the breakdown voltage varies depending on a rated voltage of a coil or an insulating material. Hereinafter, a ratio of a target breakdown voltage to an initial value is expressed as a percentage.

In the first step (step 1), the potential measuring probe 19 of Fig. 4 is moved to and fro on the outer surface of the insulating layers 13 or is brought near the measurement electrodes 24a, 24b, and 24s of Fig. 26 to measure a potential.

The breakdown voltage is derived from the prepared breakdown voltage-internal electrode potential characteristic diagram based on ratios Va/E and Vb/E of the measured potentials Va (two-layer internal electrodes) and Vb (three-layer internal electrodes) to the applied voltage E.

In this way, in this embodiment, the breakdown voltage-internal electrode potential characteristic diagram is prepared based on experimental data or the like, so that the breakdown voltage can be readily determined based on the measured potentials Va and Vb.

Further, the potentials of the internal electrode cannot be directly measured, and instead, the potential at the outer surface of the insulating layer is measured. However, these potentials are approximate to each other. Thus, for ease of explanation, the measurement of the potential at the outer surface is referred to as "measurement of an internal electrode potential" or the potential at the outer surface is referred to as "internal electrode potential".

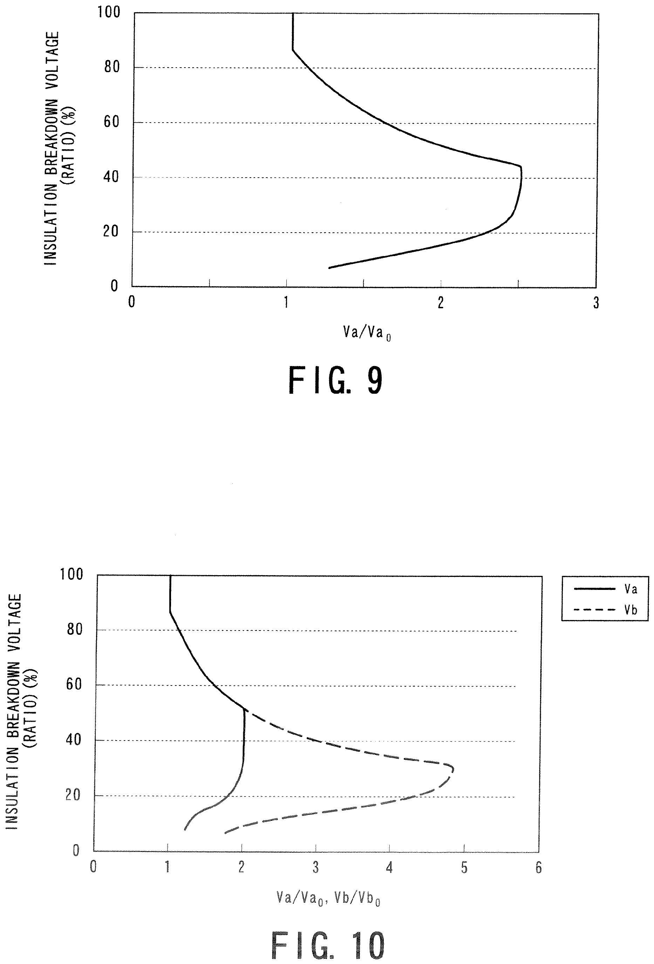

Figs. 9 and 10 are breakdown voltage-ratio between internal electrode potentials and initial values characteristic diagram in the first step (step 1) of the coil residual life predicting method according to the second embodiment of the present invention.

According to this embodiment, although the potential increases due to the leakage of the cooling water supplied to the conductor into the insulating layer, the increasing rate is important. Based on this, if the relation between the breakdown voltage and a ratio between internal electrode potentials and initial values is previously determined, the breakdown voltage can be readily estimated.

Fig. 9 is a breakdown voltage-ratio between internal electrode potentials and initial values characteristic diagram showing a relation between the breakdown voltage and a ratio between a potential V14a of an internal electrode "a" of a coil including two (two-layer) internal electrodes and initial values.

Fig. 10 is a breakdown voltage-ratio between internal electrode potentials and initial values characteristic diagram showing a relation between the breakdown voltage and a ratio between potentials Va and Vb of internal electrodes 14a and 14b of a coil including three (three-layer) internal electrodes and initial values (referred to as $Va_0$ and $Vb_0$).

Here, the initial values $Va_0$ and $Vb_0$ are determined by measuring during manufacturing of the coil or at the initial stage of the coil operation, or by measuring potentials of many coils at the time of measuring the potentials Va and Vb and selecting values determined as normal values in the measurement value distribution. To give a specific example of the latter case, as the simplest method, an average value of all measurement data may be used.

As described above, if the breakdown voltage-ratio between internal electrode potentials and initial values characteristic diagram of Fig. 9 or 10 is previously created by experiment, an increase over the initial value can be calculated by measuring the internal electrode potential to thereby estimate the breakdown voltage.

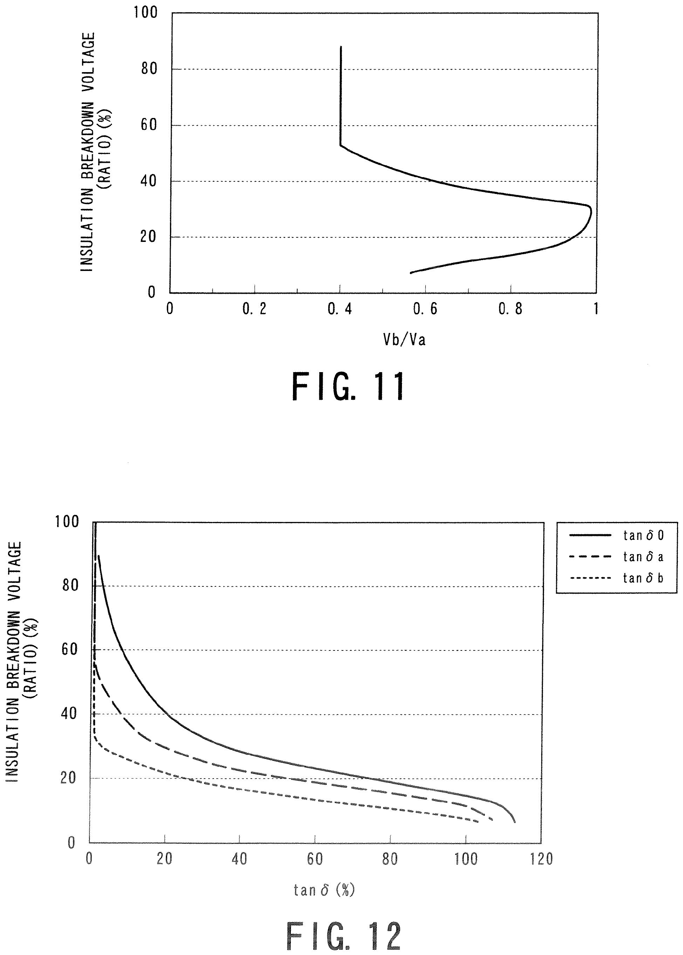

Fig. 11 is a breakdown voltage-ratio between internal electrode potentials and initial values characteristic diagram in the first step (step 1) of a coil residual life predicting method according to a third embodiment of the present invention.

In this embodiment, a ratio between potentials of two adjacent electrodes in the layer structure of a coil including three or more (three-layer) internal electrodes, that is, two or more (two-layer) internal electrodes of a floating potential (in the case of two internal electrodes of a floating potential, Vb/Va) is constant (see Table 1) if the conductor cooling water leaks and infiltrates in between the two internal electrodes, and otherwise, the ratio increases.

A relation between the ratio between the two internal electrode potentials and the breakdown voltage is previously determined by experiment, and the breakdown voltage is estimated based on the determined ratio between the potentials of the two adjacent internal electrodes of the coil.

In this way, according to this embodiment, if the breakdown voltage-ratio between internal electrode potentials and initial values characteristic diagram is prepared, the breakdown voltage can be readily estimated.

Fig. 12 is a breakdown voltage-ratio between internal electrode potentials and initial values characteristic diagram in the first step (step 1) of a coil residual life predicting method according to a fourth embodiment of the present invention.

If the conductor cooling water supplied to the conductor leaks to the insulating layer, the dielectric characteristic of the insulating layer changes.

The dielectric characteristic includes a capacitance, a dielectric loss, a dielectric loss angle, a dielectric tangent ($\tan\delta$), and moment. These can be all utilized even if the leaked water infiltrates into the insulating layer.

However, the former two factors (capacitance and dielectric loss) are changed along with the change in internal electrode size or insulating layer thickness, while the latter three factors (dielectric loss angle, dielectric tangent, and moment) are independent of the change in internal electrode size or insulating layer thickness.

On the other hand, since an operator manually winds an insulating tape around the conductor near a clip at the coil end portion, the thickness of the insulating layer is non-uniform. Further, a fixing member for fixing the coil is provided at the coil end portion. In some cases, the measurement electrode size varies depending on the coil.

The following examples use the dielectric tangent ($\tan\delta$), for example, among he latter three factors in consideration of these points.

Fig. 12 is a breakdown voltage-ratio between internal electrode potentials and initial values characteristic diagram for a coil including three (three-layer) internal electrodes. Fig. 12 is a chart of a dielectric tangent $\tan\delta0$ of the conductor after the cooling water leaks to the insulating layer from the conductor, a dielectric tangent $\tan\delta a$ of the first internal electrode "a", and a dielectric tangent $\tan\delta b$ of the second internal electrode "b".

According to the present invention, even if the measurement electrode size varies depending on the insulating layer due to limitations on the structure, the leakage of the conductor cooling water to the insulating layer can be readily and surely grasped.

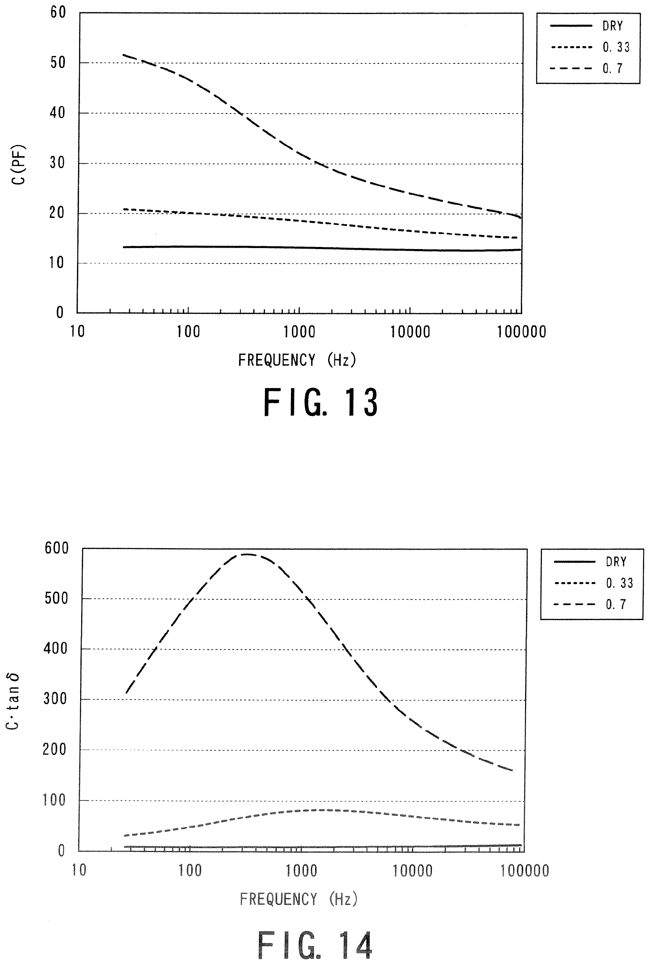

Referring next to Figs. 13 to 16, a fifth embodiment as means for checking leakage of the conductor cooling water to the insulating layer in the first step (step 1) is described.

This embodiment is based on the phenomenon that if the conductor cooling water leaks to the insulating layer, the dielectric characteristic has higher dependence on a frequency in accordance with a leakage amount of the conductor cooling water. Fig. 13 shows frequency characteristic of a capacitance between three (three-layer) internal electrodes and measurement electrodes, and Fig. 14 shows frequency characteristics as the product of the capacitance by the dielectric tangent.

In Figs. 13 and 14, the solid line represents characteristics of a dry insulating layer, the dotted line represents characteristics of an insulating layer about 3% of which is damped with the conductor cooling water, and the dashed line represents characteristics of an insulating layer about 70% of which is damped with the conductor cooling water.

As apparent from Figs. 13 and 14, if no conductor cooling water leaks to the insulating layer, the dependency on a frequency of the dielectric characteristics is extremely low. In contrast, if the conductor cooling water leaks to the insulating layer, the dependency on the frequency of the dielectric characteristics becomes high.

For example, a relation between dielectric characteristics of 1 kHz/dielectric characteristics of 10 kHz and a percentage of conductor cooling water that leaks to the insulating layer is shown in a chart of the breakdown voltage-change in dielectric characteristics with frequency.

As apparent from the chart of the breakdown voltage-change in dielectric characteristics with frequency, the dependency on the frequency of the dielectric characteristics correlates with the breakdown voltage.

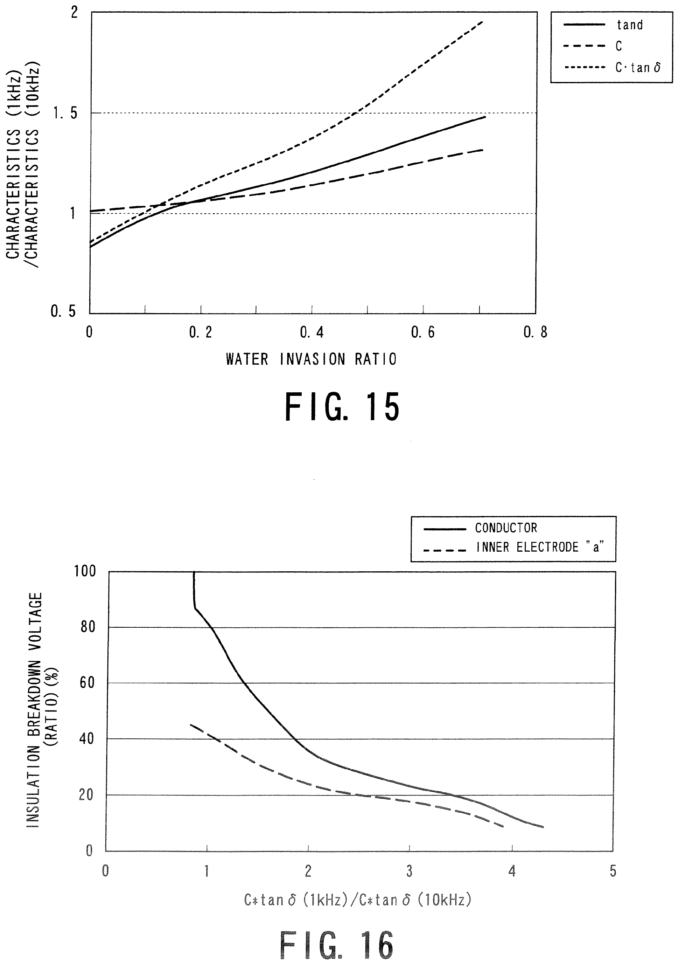

On the other hand, Fig. 16 is a chart of the breakdown voltage-change in dielectric characteristics with frequency of a coil including two (two-layer) internal electrodes.

In Fig. 16, the solid line represents a ratio between measurement values at 1 kHz and 10 kHz as the product of the dielectric tangent by a capacitance between the conductor and the measurement electrode attached to the insulating layer surface on the conductor near the clip of the coil having no internal electrode. The broken line represents a ratio between measurement values at 1 kHz and 10 kHz as the product of the dielectric tangent by a capacitance between the conductor and the measurement electrode attached to the insulating layer surface on the internal electrode.

In the chart of the breakdown voltage-change in dielectric characteristics with frequency of Fig. 16, the measurement is executed using the same electrode with only the frequency changed at the same position, so measurement accuracy is high since data less varies, and the measurement result does not depend on the internal electrode size and the insulating layer thickness.

As described above, in this embodiment, if the chart of the breakdown voltage-change in dielectric characteristics with frequency is previously created, the breakdown voltage can be readily and simply estimated by measuring and comparing dielectric characteristics with at least two frequencies.

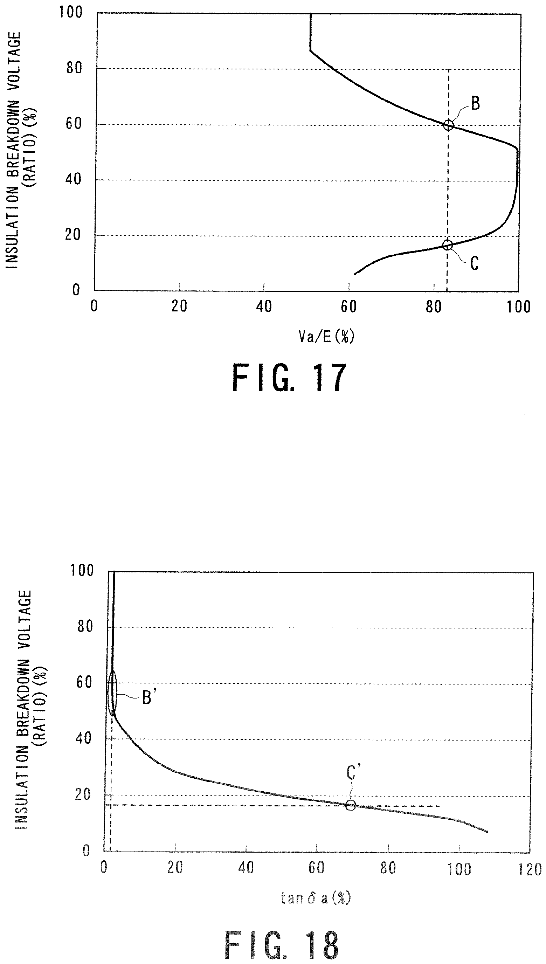

Figs. 17 and 18 are characteristic diagrams showing a breakdown voltage-internal electrode potential characteristic in the first step (step 1) of a coil residual life predicting method according to a sixth embodiment of the present invention.

As a method of estimating the breakdown voltage of the coil insulating layer, determined are breakdown voltage values corresponding to internal electrode potentials measured using the breakdown voltage-internal electrode potential characteristic diagram, a breakdown voltage-ratio between internal electrode potentials and initial values characteristic diagram, and a breakdown voltage-ratio between adjacent internal electrode potentials and initial values characteristic diagram as shown in Figs. 7 to 11.

In this case, two breakdown voltage values are determined for one measurement value.

Referring to Fig. 17, a way how to determine the breakdown voltage value in such a case is described.

Fig. 17 is a characteristic diagram showing a breakdown voltage-internal electrode potential characteristic, which demonstrates a relation between the breakdown voltage and the potential Va of the internal electrode "a" of the coil including three (three-layer) internal electrodes as shown in Fig. 8.

In Fig. 17, if the potential Va is 83%, two breakdown voltage values, that is, 59% (point B) and 17% (point C) are obtained.

On the other hand, as shown in Fig. 18, the dielectric tangent tan$\delta$a of the insulating layer on the internal electrode "a" is 1.8% (B' region). This tangent tan$\delta$a of 1.8% is a pre-stage (B') just before the abrupt increase, in which the breakdown voltage is supposed to be about 50% or more.

In consideration of the fact that the breakdown voltage is about 50% or more under the condition of the dielectric tangent tan$\delta$a of 1.8%, the breakdown voltage is estimated as 59% (point B of Fig. 17) when the potential Va is 83%.

If the breakdown voltage drops down to 17% (point C of Fig. 17), as apparent from Fig. 18, the dielectric tangent tan$\delta$a = 69% (point C'). Even if the measurement accuracy is low, it is impossible to mistake the dielectric tangent tan$\delta$a of 2% for the dielectric the tangent tan$\delta$a of 69%.

Therefore, the breakdown voltage never drops down to 17%, and is estimated as 59%.

In this way, in this embodiment, in the case of determining the breakdown voltage from the breakdown voltage-internal electrode potential characteristic diagram, the determination is executed in combination with the breakdown voltage-dielectric characteristic diagram, so that an appropriate breakdown voltage value can be obtained.

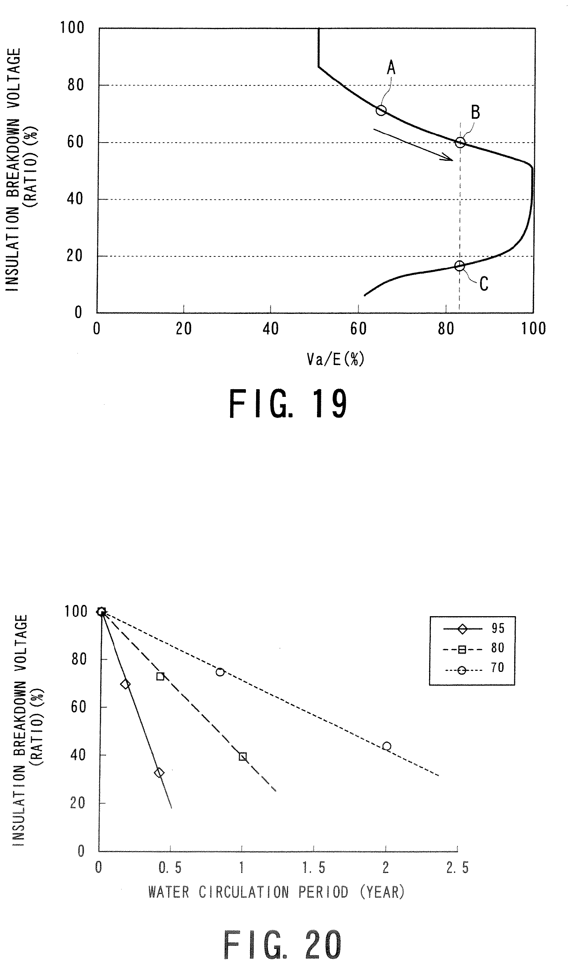

Fig. 19 is a breakdown voltage-internal electrode potential characteristic diagram in the first step (step 1) of a coil residual life predicting method according to a seventh embodiment of the present invention.

In the case of estimating the breakdown voltage of the coil insulating layer, in the sixth embodiment, the breakdown voltage-internal electrode potential characteristic diagram is referenced in combination with the breakdown voltage-dielectric characteristic diagram to select an appropriate value from the obtained two breakdown voltage values based on the change in breakdown voltage with time.

Fig. 19 shows an example of the above procedure.

For example, if the potential Va measured before 1 year is 65%, the breakdown voltage is estimated as 71% (point A) based on the measurement result of the dielectric tangent tanδ.

On the other hand, if the potential Va measured this time is 83%, the breakdown voltage cannot abruptly drop down to 17% (point C) in one year and thus is estimated as 59% (point B) based on a speed at which the conductor cooling water leaks to the insulating layer.

As mentioned above, in this embodiment, the change in measured potential with time is taken into consideration with respect to the two breakdown voltage values calculated from the breakdown voltage-internal electrode potential characteristic diagram, and thus, an appropriate breakdown voltage can be selected.

Next, there will be described a method of determining a decreasing rate of the breakdown voltage in the second step (step 2) of the coil residual life predicting method according to the first embodiment.

This embodiment uses a coil prepared by removing a part of the insulating layer covering the clips of 6 coils not subjected to leakage of the conductor cooling water to the insulating layer, forming a 0.3-mm φ hole in one hollow elemental wire and ensuring a clearance around the hole not to block the leakage of the water from the hollow wire and reinsulating the coils.

Upon the test operation, ion-exchanged water the temperature of which is set to 95°C, 80°C, and 70°C under the control is circulated through every two coils.

Then, the internal electrode potential is periodically measured to estimate the breakdown voltage based on how much the cooling water leaks to the insulating layer and the breakdown voltage-internal electrode potential characteristic diagram. Further, right and left coil end portions of the two coils through which the ion-exchanged water is circulated at each temperature (95°C, 80°C, and 70°C) are independently subjected to breakdown at different timings.

After the breakdown voltage, a relation between the hot water circulation period of the ion-exchanged water and the breakdown voltage is mapped into the breakdown voltage-hot water circulation period diagram as shown in Fig. 20.

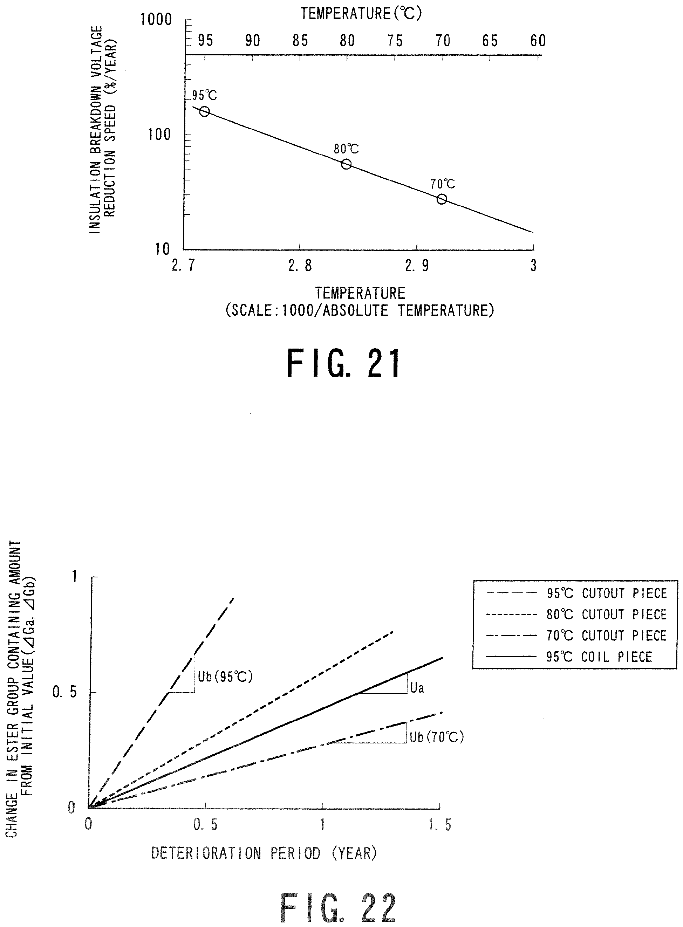

Next, in order to obtain the relation between the temperature of the circulating water and the decreasing rate of the breakdown voltage, in this embodiment, a chart (called "Arrhenius plot") is created as shown in Fig. 21 based on a gradient (slope) of Fig. 20. In Fig. 21, the vertical axis represents the logarithm of the decreasing rate of the breakdown voltage, and the horizontal axis represents the reciprocal of the absolute temperature.

In this way, in this embodiment, since the breakdown voltage decreasing rate-temperature characteristic diagram of Fig. 21 is previously created, the decreasing rate of the breakdown voltage at a given temperature can be readily obtained.

Incidentally, the defect or corrosion of the brazed portion variously changes. Thus, if the test is executed with the size or number of holes formed in the above hollow elemental wire, influences on the speed at which the leaked water infiltrates into the insulating layer, and the decreasing rate of the breakdown voltage can be grasped based on a difference in amount of the leaked water that infiltrates in the insulating layer.

Further, in this embodiment, the hole is artificially formed in the hollow elemental wire to guide the water to the outside. However, the coil suffering the water leakage during the operation of the generator may be taken off from the generator and used as a sample of the hot water circulation test. In this case, although the variation is large, there is an advantage in that the test can be executed under conditions similar to the actual conditions.

Figs. 22, 23, and 24 are charts illustrating a method of determining the decreasing rate as second and third embodiments of the breakdown voltage in the second step (step 2) of the coil residual life predicting method according to the first embodiment.

This embodiment determines the decreasing rate of the breakdown voltage at a given temperature through the coil hot water circulation test at one temperature and a hygrothermal aging test using a test piece of the insulating layer at plural temperatures.

That is, as the degradation (referred to as hygrothermal aging) of the insulating layer due to the water and temperature proceeds, chemical bonds of a resin in the insulating layer, for example, an epoxy resin deform due to hydrolysis, and contents of a specific group change. An ester group typifies the specific group. If the rein contains the ester group, the bond between the ester groups is broken due to the hydrolysis to generate an organic acid and hydroxyl groups.

Thus, the hydrothermal aging degree correlates with the ester group decreasing degree or the increasing degree of the organic acid or the hydroxyl group.

This embodiment utilized such phenomenon, and tests the dependency on the temperature of the hydrothermal aging rate using the sample (test piece) of the insulating layer to determine the decreasing rate of the breakdown voltage at a given temperature based on the test result and the degradation test result at one temperature for the actual coil.

The determined decreasing rate of the breakdown voltage (-d (BDV)/dt, BDV: breakdown voltage, t: time) is modified as follows.

[Expression 2]

$$-d(BDV)/dt = \{d(BDV)/d\ (\text{ester group contents})\} \times \{d\ (\text{ester group contents})/dt\} \ \dots \ (3)$$

The first term of the right side of Expression (3) is calculated using the actual coil hot water circulation test or the actual operating coil, and the second term is calculated using the hygrothermal aging test of the test piece of the insulating layer.

Hereinafter, a method of determining the decreasing rate of the breakdown voltage based on the temperature dependency of the hydrothermal aging speed is detailed.

In this embodiment, in the step A, the test similar to the hot water circulation test in the second step (step 2) of the coil residual life predicting method of the first embodiment of the invention is executed at only one temperature in the coil hot water circulation test at one temperature. The test temperature may be set based on the test period but is preferably set high since the higher temperature enables a shorter test period. To give an example thereof, the ion-exchanged water of 95°C is circulated through several conductors, and the coil dielectric test is executed after 2 and 5 months to determine the breakdown voltage. The breakdown voltage-hot water circulation time chart (plot at 95°C of Fig. 20) is created based on the test result, and the decreasing rate of the breakdown voltage at one temperature, 95°C, of the coil is determined as apparent from the slope of the diagram.

After the coil dielectric test, in this embodiment, the insulating layer is disassembled and sampled to measure the contents Ga of the ester group as the specific group S in the insulating layer using infrared absorption spectrum.

Next, in the step B, the insulating layer not damped with the leaked conductor cooling water is cut into a test piece of a rectangular shape measuring, for example, 40 mm x 50 mm and immersed in the ion-exchanged water where the conductor cooling water temperature is set to 95°C, 80°C, and 70°C, for example, under the control and then taken out at predetermined intervals to measure the ester group contents Gb in the insulating layer using the infrared absorption spectrum.

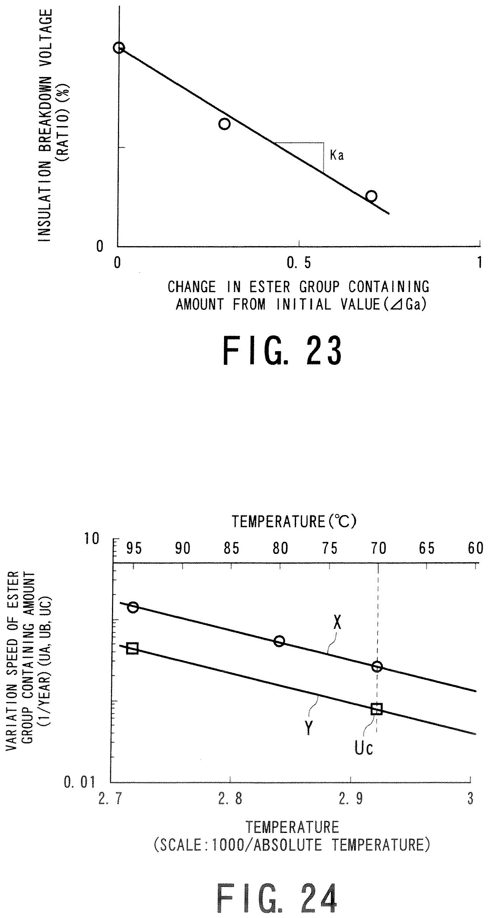

Further, the change of the ester group contents Ga and Gb from the initial ester group contents $Ga_0$ and $Gb_0$ (non-degradation state) rather than the absolute values is important. Thus, differences therebetween $\Delta Ga$ and $\Delta Gb$ ($\Delta G = |G - G_0|$) may be used. In the following data processing, the differences $\Delta Ga$ and $\Delta Gb$ are used instead of the ester group contents $\Delta Ga$ and $\Delta Gb$. In the case of using the differences $\Delta Ga$ and $\Delta Gb$, the axes of graphs of Fig. 22 and 23 may be shifted by $Ga_0$ and $Gb_0$. Thus, the gradient of the graph is not changed and the final result is the same.

Fig. 22 shows a relation between the degradation period and the thus-obtained differences $\Delta Ga$ and $\Delta Gb$ from the initial values of the ester group contents. Further, Fig. 23 shows a relation between the coil breakdown voltage and the difference $\Delta Ga$ from the initial value of the ester group contents Ga in the insulating layer of the coil. The gradient (slope) of the regression line of the plot in the chart of Fig. 23 represents the ester group content dependency Ka of the coil breakdown voltage and corresponds to the first term of the right side of Expression (3).

Next, in the step C, the relation between the degradation temperature and the change rate (Ua for the coil and Ub for the test piece) of the ester group contents calculated from the gradient (slope) of the chart of Fig. 33 is Arrhenius-plotted. Fig. 24 shows this pot.

In Fig. 24, the regression line X is drawn to pass points where three temperatures (95°C, 80°C, and 70°C) are blotted for the test piece of the insulating layer, and the estimated line representing the temperature dependency of the ester coil content change rate of the actual coil is drawing in parallel to the regression line X so as to pass the points where the change rate of the ester content with time of the actual coil is plotted. The change rate Uc with time of the ester contents in the coil insulating layer at a given temperature is calculated from the estimated line Y. For example, if the coil conductor temperature during the operation of the generator is 70°C, as apparent from Fig. 24, the change rate Uc with time of the ester contents is (estimated as) 0.08/year. The change rate Uc with time of the ester contents at the predetermined temperature corresponds to the second term of the right side of Expression (3).

The product of the thus-determined ester content dependency Ka of the coil breakdown voltage by the change rate Uc with time of the ester contents at the coil operating temperature is the decreasing rate of the breakdown voltage at the coil operating temperature.

Furthermore, in this embodiment, the ester content is used as the degradation amount. However, the present invention is not limited thereto, and an increase in contents of the organic acid may be analyzed using any chemical analyzer and used in place of the ester group of Expression (3). In some resins, the other groups change contents thereof more sensitively due to the hydrolysis, the groups may be analyzed and used.

Further, in the above embodiments, the test pieces cut out from the normal coil is immersed in the ion-exchanged water set to 95°C, 80°C, and 70°C under the control. In this case, the entire surface of the test piece is brought into contact with the water. On the other hand, in the actual coil, the water infiltrates only from the conductor alone, so the degradation may proceed more slowly than the test piece. Accordingly, in order that the degradation on the test piece due to the hot water is made closer to the actual one, five surfaces out of six surfaces are sealed with a metal plate or a moisture-resistant epoxy resin or the like, and the remaining one surface is brought into contact with the hot water. Alternatively, the test piece is pressed against an opening of a container filled with the water and only one surface of the test piece contacts the hot water. If the hydrothermal aging test is carried out in this way, the degradation condition can be similar to those of the actual coil.

As mentioned above, in this embodiment, the large-scale test using the coil is limited to one temperature. As for the temperature dependency of the hydrothermal aging speed, there is an advantage in that the test piece is used to measure and analyze contents of a chemically specific group susceptible to a change due to the hydrothermal aging in the laboratory, so that the degreasing rate of the breakdown voltage can be determined in a short time with a small-scale test as compared with the method of determining the decreasing rate of the breakdown voltage only through the hot-water circulation test as described in the first embodiment.

Next, a fourth embodiment of the method of determining the decreasing rate of the breakdown voltage in the second step (step 2) of the coil residual life predicting method according to the first embodiment of the present invention is described.

In the case of determining the decreasing rate of the breakdown voltage, in the test using the coil of the first and second embodiments in the second step (step 2), a high voltage is not applied during the circulation test using the ion-exchanged water.

However, if the insulting layer is applied with a voltage, a force (Maxwellian stress) that a substance of a high dielectric constant infiltrates acts in the insulating layer with a high electric field, and the ion-exchanged water infiltrates more quickly than the insulating layer with no electric field.

Further, at the stage where the infiltration of the ion-exchanged water proceeds, higher electric field is applied to the insulating layer not damped with the ion-exchanged water, so that electric degradation proceeds at higher speeds. Thus, it is necessary to grasp an influence of the voltage.

This embodiment considers this drawback. A degradation test was executed for both of the case of applying the high voltage between the conductor and the semiconductor layer at the surface of the coil linear portion and the case of applying no voltage at the time of circulating the ion-exchanged water controlled to the predetermined temperature through the coil conductor, the test results of the two cases were compared, and the influence on the decreasing rate of the breakdown voltage due to the voltage application other than the temperature of the ion-exchanged water was grasped.

A specific example thereof is given below. The test using the coil of one of the first to third embodiments in the second step (step 2) is first implemented. As a result of the test, a decreasing rate DRBDV (voltage non-application) of the breakdown voltage due to the water leakage is obtained. Plural sample coils completely the same as those used in the above test are used to circulate the ion-exchanged water controlled to the predetermined temperature through the coil conductor while being kept at a constant pressure concurrently or not concurrently with the above test. At this time, the conductors of the coils are grounded, and a predetermined voltage is applied to a low-resistance layer of the coil linear portion. The dielectric test is executed at plural points different in the degree at which the leaked water infiltrates to thereby determine the breakdown voltage and create the breakdown voltage-hot water circulating period chart. Based on the gradient thereof, the decreasing rate DRBDV (voltage application) of the breakdown voltage due to the leakage under the voltage application is obtained. An acceleration factor due to the voltage application is derived from DRBDV (voltage application)/DRBDV (voltage non-application).

In Fig. 2, the estimated line L representative of a further decreasing rate of the breakdown voltage may be drawn using the rate DRBDV (voltage application) for the coil that would be largely influenced by the voltage.

Incidentally, the applied voltage is generally a value between the rated voltage (interline voltage) and rated voltage/$\sqrt{3}$ (ground potential) but may be other voltage in consideration of the acceleration degree of the degradation due to the hot water temperature.

Further, the test is executed using plural application voltages, the acceleration factor of the degradation due to the voltage application can be more clearly defined, and the degreasing rate of the breakdown voltage can be more accurately defined for coils applied with different levels of voltage.

In this way, in this embodiment, at the time of circulating the ion-exchanged water through the conductor, the voltage is applied to the coil, so the decreasing rate of the breakdown voltage can be determined under the conditions closer to the actual operating conditions.

Fig. 25 is a coil breakdown voltage-operating period chart for illustrating a method of determining a decreasing rate of the breakdown voltage as a fourth embodiment in the second step (step 2) of the coil residual life predicting method according to the first embodiment of the present invention.

In the case of determining the decreasing rate of the breakdown voltage, in the first to third embodiments, the decreasing rate of the breakdown voltage is determined based on the experimental data measured in the laboratory, but in this embodiment, the decreasing rate of the breakdown voltage is determined during the maintenance of the actually operating coil.

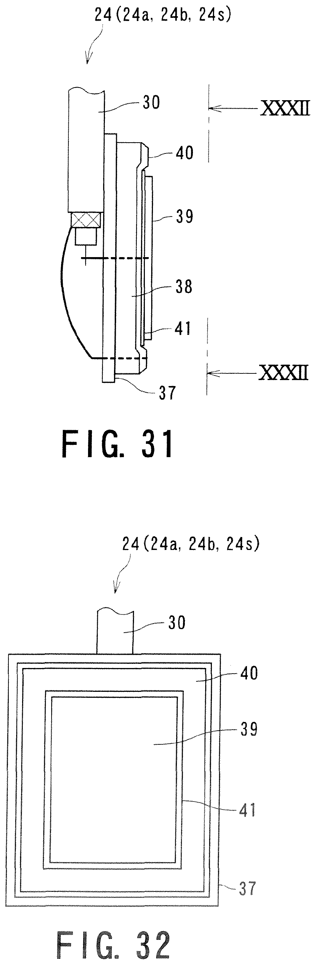

That is, in this embodiment, the internal electrode potential of the actually operating coil is periodically measured, or the measurement electrode is attached to the outer surface of the insulating layer on the clip side rather than the range of the internal electrode, dielectric characteristics between the conductor and the measurement electrode are measured, a timing (in Fig. 25, S) at which the leaked conductor cooling water starts infiltrating into the insulating layer is grasped based on the change in measurement value, and after the elapse of a predetermined period of, for example, 2 years (in Fig. 25, Δt), the coil is taken off to determine the breakdown voltage. Then, the decreasing rate ΔV/Δt (in Fig. 25, 31%/2 years =15.5%/year) of the coil breakdown voltage is estimated based on the operation period Δt from the timing S at which the leaked conductor cooling water starts infiltrating into the insulating layer to the removal of the coil (for example, 2 years) and a difference Δt between the estimated value (for example, in Fig. 25, 88%) of the breakdown voltage in the case where no conductor cooling water leaks at the time of removing the coil and the current breakdown voltage (for example 57%).

In this embodiment, it takes much time to determine the decreasing rate of the coil breakdown voltage, but the degradation state of the insulating layer and the coil actual operating conditions are sufficiently considered, so the more accurate decreasing rate of the coil breakdown voltage can be calculated.

Incidentally, in the test of the first to fourth embodiments in the second step (step 2) of determining the decreasing rate of the breakdown voltage, after measuring the internal electrode potential of the insulating layer and dielectric characteristics between the surface electrode attached to the insulating layer and the underlying conductor or internal electrode, the breakdown voltage is determined. Thus, if the relation between the breakdown voltage and the measurement results is found based on the test result, the breakdown voltage-internal electrode potential characteristic diagram, the breakdown voltage-ratio between internal electrode potentials and initial values characteristic diagram, the breakdown voltage-ratio between adjacent internal electrode potentials and initial values characteristic diagram, the breakdown voltage-dielectric characteristic diagram, and the breakdown voltage-change in dielectric characteristics with frequency diagram can be created. These diagrams are used in the first to seventh embodiments of the method of estimating the breakdown voltage in the first step.

Next, a coil residual life predicting apparatus according to a first embodiment of the preset invention is described.

Fig. 26 is a conceptual view showing a coil residual life predicting apparatus of the present invention where a measurement electrode is attached to the outer surface of an insulating layer of a coil for measuring the dielectric characteristics of the insulating layer.

As an insulating structure of the coil, the conductor 12 and the clip 17 are covered with the insulating layers 13 (first insulating layer 13a, the second insulating layer 13b, and the third insulating layer 13c) which include the first internal electrode 14a, the second internal electrode 14b, and the third internal electrode 14g. The measurement electrodes 24a, 24b, and 24s are attached to the outer surface of the insulating layer, and a voltage is applied between the first internal electrode 14a, the second internal electrode 14b, and the conductor 12 to measure the dielectric characteristics.

However, since positions of the internal electrodes 14a, 14b, and 14g are visually checked from the outside, there is a possibility of occurrence of a defect such as a measurement error depending on an installation position of the measurement electrodes 14a, 14b, and 14s.

Therefore, in this embodiment, at the time of setting the measurement electrodes 24a, 24b, and 24s along the axial direction of the coil, the surface potential measurement probe (not shown) is first moved to and fro on the outer surface of the insulating surface to measure the surface potential as shown in Fig. 26 and then, the measurement electrodes 24a, 24b, and 24s are attached in positions where the surface potential is stabilized.

In this embodiment, since the measurement electrodes 24a, 24b, and 24s are attached to the outer surface of the insulating layer in this way, there is no displacement among the measurement electrodes 24a, 24b, and 24s to thereby suppress the measurement error.

Hereinafter, a second embodiment of a coil residual life predicting apparatus of the present invention will be described.

The measurement of a capacitance between the measurement electrodes attached to the outer surface of the insulating layer and the internal electrode needs ingenious method and idea because the measurement electrodes cannot be directly connected with the internal electrode.

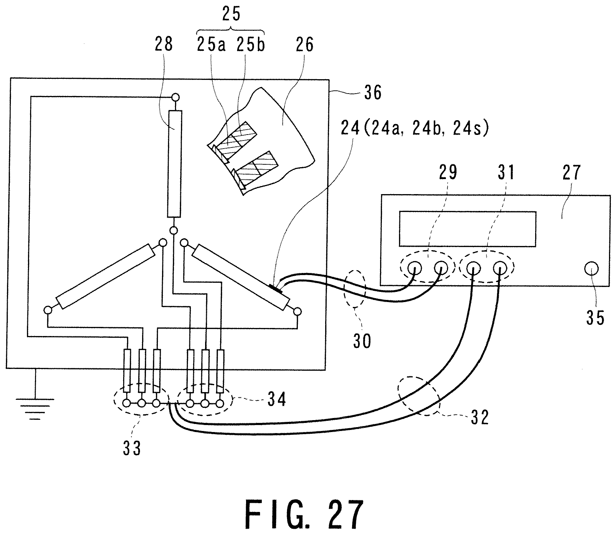

Fig. 27 is a conceptual view showing the connection between the dielectric characteristic measuring apparatus and the coil used for measuring the dielectric characteristic of the insulating layer at the coil end portion of the turbine generator, for example.

In Fig. 27, winding 28 parallelly or serially connected with a number of coils is illustrated in a rectangular shape on a phase basis.

In practice, as shown in a sectional view of a cutout portion, the linear portion of each coil 25 (25a and 25b) is inserted into the groove of the iron core 26. The measurement electrode 24 (24a, 24b, and 24s) is attached to a given position of the coil end portion, and one end of a coaxial cable 30 is connected with a low-pressure terminal 29 of a dielectric characteristic measuring apparatus 27 and the other end thereof is connected with the measurement electrode 24 (24a, 24b, and 24s).

Further, one end of a coaxial cable 32 is connected with a high-pressure terminal 31 of the dielectric characteristic measuring apparatus 27 and the other end thereof is connected with at least one of an output terminal 33 of a generator and a neutral terminal 34.

The ground terminal or guard terminal 35 of the dielectric characteristic measuring apparatus 27 is not grounded.

With such connection structure, a capacitance characteristic (capacitance, dielectric loss, dielectric loss angle, dielectric tangent, and moment) is measured. Then, the internal electrode of a floating potential and the measurement electrode have substantially the same potential due to the large capacitance between the internal electrode and the conductor, so that the voltage generated by the dielectric characteristic measuring apparatus 27 is all applied between the internal electrode and the measurement electrode 24 (24a, 24b, and 24s) to thereby measure the dielectric characteristic with high accuracy.

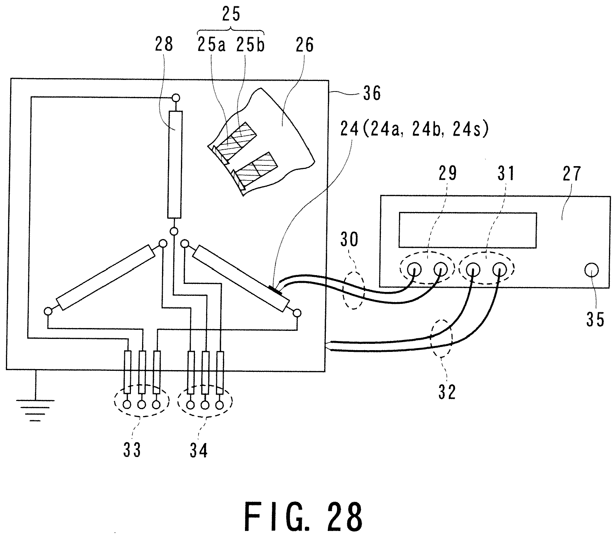

Incidentally, in this embodiment, the high-pressure terminal 31 of the dielectric characteristic measuring apparatus 27 is connected with the output terminal 33 and the neutral terminal 34, but the present invention is not limited thereto. For example, as shown in Fig. 28, the high-pressure terminal 31 of the dielectric characteristic measuring apparatus 27 may be connected with a casing 36 of the generator that accommodates the coil.

With such connection structure, the capacitance characteristic (capacitance, dielectric loss, dielectric loss angle, dielectric tangent, and moment) is measured. Then, in this embodiment, the internal electrode of a floating potential has substantially the same potential as the ground potential, that is, as the casing 36 potential due to the large capacitance between the outermost internal electrode 14g (not shown) of the ground potential and the internal electrode.

Hence, according to the present invention, the voltage generated by the dielectric characteristic measuring apparatus 27 is substantially all applied between the internal electrode and the measurement electrode 24 (24a, 24b, and 24s) to thereby measure the dielectric characteristic with high accuracy.

Incidentally, the connection position of the coaxial cable may take any position instead of the casing 36 of the generator as long as the potential at the position is equal to the potential of the iron core 26 accommodated in the casing 36. For example, the cable 32 may be directly connected with a part of the iron core 26.

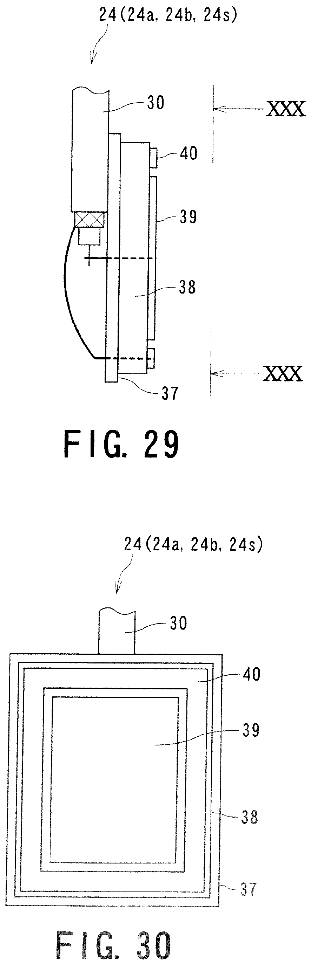

Further, as for the measurement electrode 24 (24a, 24b, and 24s), if an flexible member 38 of high insulating property such as soft rubber or sponge is attached to an insulating plate 37 as shown in Figs. 29 and 30, and an electrode portion 39 and a guard electrode 40 are arranged thereon, or an insulating sheet 41 is inserted between the electrode portion 39 and the guard electrode 40 and core wire of the coaxial cable 30 and a sealing portion are connected with the electrode portion 39 and the guard electrode 40 as shown in Figs. 31 and 32, the electrode portion 39 and the guard electrode 40 can be brought into close contact with the coil surface, and the guard electrode 40 suppresses the disturbance of the electric field around the electrode portion 39 that causes an error to thereby realize high-accuracy measurement.

Industrial Applicability

Up to now, in the rotating electric apparatus, for example, if the capacitance is increased, the Joule heat loss at the stator coil leads to extremely high temperatures, which hinders the safe operation. Thus, there is a demand for a technique capable of precisely predicting a coil residual life in the case where, during the operation with the conductor directly cooled with the cooling water, if the cooling water leaks from the conductor and infiltrates into the insulating layer.

According to the present invention, it is possible to provide a coil residual life predicting method and apparatus capable of estimating a breakdown voltage of an insulating layer and predicting a residual life based on the estimated breakdown voltage for the coil suffering the leakage of the cooling water from the conductor into the insulating layer, without removing the coil and damaging any component. Thus, the residual life of the coil can be easily and simply predicted without damaging any component, making it possible to speedily respond to quick exchange and maintenance of a coil. Thus, the high-accuracy dielectric characteristics can be measured, and the coil residual life can be more accurately predicted. Consequently, the present invention is applicable to other industrial fields than the art concerned.

**Claims**

1.  A coil residual life predicting method comprising:

    a first step of checking whether or not cooling water from a conductor leaks to an insulating layer, and executing measurement necessary for estimating a breakdown voltage of a coil plural times with time if the conductor cooling water leaks to the insulating layer to estimate a breakdown voltage of a coil, and estimating a breakdown voltage of a coil each time the measurement is executed, the estimating step further including of applying an alternative voltage to a conductor of the coil, measuring an internal electrode potential at an outer surface of an insulating layer on an internal electrode, and calculating a breakdown voltage corresponding to the measured internal electrode potential based on a previously created breakdown voltage-internal electrode potential characteristic diagram;

a second step of drawing and extrapolating a curve representing a change of the breakdown voltage with time to predict a future decreasing tendency of the breakdown voltage; and

a third step of determining a period necessary for the breakdown voltage to drop down to a voltage necessary for operating the coil based on the curve representing the change with time.

2. The coil residual life predicting method according to claim 1, wherein the first step of estimating the breakdown voltage of the coil includes applying an alternative voltage to a conductor of the coil, measuring an internal electrode potential at an outer surface of an insulating layer on an internal electrode, determining a ratio between the measured internal electrode potential and an initial value of the internal electrode potential or an internal electrode potential of the coil determined not to suffer leakage of the conductor cooling water into the insulating layer, and calculating a breakdown voltage corresponding to the determined ratio based on a previously created breakdown voltage-ratio-between-internal electrode-potential-and-initial-value characteristic diagram.

3. The coil residual life predicting method according to claim 1, wherein the first step of estimating the breakdown voltage of the coil includes applying an alternative voltage to a conductor of the coil, measuring an internal electrode potential at an outer surface of an insulating layer on an internal electrode, determining a ratio between adjacent internal electrode potentials, and calculating a breakdown voltage corresponding to the determined ratio based on a previously created breakdown voltage-ratio-between-adjacent-internal electrode-potentials characteristic diagram.

4. The coil residual life predicting method according to claim 1, wherein the first step of estimating the breakdown voltage of the coil includes attaching a measurement electrode to an outer surface of an insulating layer including the internal electrode and an outer surface of an insulating layer in a portion apart from the internal electrode, measuring dielectric characteristics between the measurement electrode and the internal electrode and between the measurement electrode and a conductor in the portion apart from the internal electrode, and calculating a breakdown voltage corresponding to the determined dielectric characteristics based on a previously created breakdown voltage-dielectric characteristic diagram.

5. The coil residual life predicting method according to claim 1, wherein the first step of estimating the breakdown voltage of the coil includes attaching a measurement electrode to an outer surface of an insulating layer including the internal electrode and an outer surface of an insulating layer in a portion apart from the internal electrode, measuring dielectric characteristics between the measurement electrode and the internal electrode and between the measurement electrode and a conductor in the portion apart from the internal electrode, determining a ratio of dielectric characteristics at two frequencies, and calculating a breakdown voltage corresponding to the determined ratio based on a previously created diagram showing a breakdown voltage-dielectric characteristic change rate with frequency.

6. The coil residual life predicting method according to claim 1, wherein the first step of estimating the breakdown voltage of the coil includes determining an appropriate breakdown voltage value if two breakdown voltage values are obtained for one internal electrode potential upon calculating the breakdown voltage based on one of a breakdown voltage-internal electrode potential characteristic diagram, a breakdown voltage-ratio-between-internal electrode-potential-and-initial-value characteristic diagram, and a breakdown voltage-ratio-between-adjacent-internal electrode-potentials characteristic diagram, in combination with a breakdown voltage-dielectric characteristic diagram.

7. The coil residual life predicting method according to claim 1, wherein the first step of estimating the breakdown voltage of the coil includes determining an appropriate breakdown voltage value if two breakdown voltage values are obtained for one internal electrode potential upon calculating the breakdown voltage based on one of a breakdown voltage-internal electrode potential characteristic diagram, a breakdown voltage-ratio-between-internal electrode-potential-and-initial-value characteristic diagram, and a breakdown voltage-ratio-between-adjacent-internal electrode-potentials characteristic diagram, based on a change of a previously measured potential.

8. The coil residual life predicting method according to claim 1, wherein the first step of estimating the breakdown voltage of the coil includes creating a breakdown voltage-internal electrode potential characteristic diagram, a breakdown voltage-ratio-between-internal electrode-potential-and-initial-value characteristic diagram, a breakdown voltage-ratio-between-adjacent-internal electrode-potentials characteristic diagram, a breakdown voltage-adjacent-electrodes characteristic diagram, and a diagram a breakdown voltage-dielectric characteristic change rate with frequency based on an internal electrode potential measured at an outer surface of an insulating layer on an internal electrode just before a dielectric test for a plurality of coils suffering leakage of cooling water, dielectric characteristics between a measurement electrode placed on the outer surface of the insulating layer and a conductor and between the measurement electrode and the internal electrode, and a breakdown voltage measured after the measurements; and estimating a breakdown voltage based on the created diagrams at subsequent measurements.

**9.** A coil residual life predicting apparatus adapted to carry out the method according to claim 1 comprising:

a non-contact surface electrometer for measuring a potential of an internal electrode provided in an insulating layer that covers a coil; and
a dielectric characteristic measuring apparatus for measuring dielectric characteristics between at least one of the internal electrode and a conductor and a measurement electrode attached to an outer surface of the insulating layer of the coil to predict a residual life based on a breakdown voltage estimated based on the measured potential,
wherein upon attaching the measurement electrode to the insulating layer, a probe of the non-contact surface electrometer is moved along the coil, and the measurement electrode is attached to the surface of the insulating layer at a position where a stable surface potential is detected.

**Patentansprüche**

**1.** Vorhersageverfahren für die Restgebrauchsdauer von Spulen, umfassend:

einen ersten Schritt des Prüfens, ob Kühlwasser aus einem Leiter in eine Isolierschicht ausläuft oder nicht, und des Ausführens einer Messung, die notwendig ist, um eine Durchschlagspannung einer Spule mehrere Male im zeitlichen Verlauf zu schätzen, wenn das Leiterkühlwasser in die Isolierschicht ausläuft, um eine Durchschlagspannung einer Spule abzuschätzen, und Schätzen einer Durchschlagspannung einer Spule jedes Mal, wenn die Messung ausgeführt wird, wobei der Schritt des Schätzens ferner enthält: Anlegen einer alternativen Spannung an einen Leiter der Spule, Messen eines inneren Elektrodenpotenzials an einer Außenfiläche einer Isolierschicht auf einer inneren Elektrode, und Berechnen einer Durchschlagspannung, die dem gemessen inneren Elektrodenpotenzial entspricht, auf der Basis eines zuvor erstellten Kennliniendiagramms von Durchschlagspannung zu innerem Elektrodenpotenzial,
einen zweiten Schritt des Zeichnens und Extrapolierens einer Kurve, die eine Änderung der Durchschlagspannung im zeitlichen Verlauf repräsentiert, um eine weitere Abnahmetendenz der Durchschlagspannung vorherzusagen,
und einen dritten Schritt des Bestimmens eines Zeitraums, den die Durchschlagspannung benötigt, um auf eine Spannung zu fallen, die zum Betreiben der Spule notwendig ist, auf der Basis der Kurve, die die Änderung im zeitlichen Verlauf repräsentiert.

**2.** Vorhersageverfahren für die Restgebrauchsdauer von Spulen nach Anspruch 1, wobei der erste Schritt des Schätzens der Durchschlagspannung der Spule enthält: Anlegen einer alternativen Spannung an einen Leiter der Spule, Messen eines inneren Elektrodenpotenzials an einer Außenfläche einer Isolierschicht auf einer inneren Elektrode, Bestimmen eines Verhältnisses zwischen dem gemessenen inneren Elektrodenpotenzial und einem Anfangswert des inneren Elektrodenpotenzials oder einem inneren Elektrodenpotenzial der Spule, von der bestimmt wurde, dass bei ihr kein Leiterkühlwasser in die Isolierschicht ausläuft, und Berechnen einer Durchschlagspannung, die dem bestimmten Verhältnis entspricht, auf der Basis eines zuvor erstellten Kennliniendiagramms eines Durchschlagspannungsverhältnisses zwischen innerem Elektrodenpotenzial und Anfangswert.

**3.** Vorhersageverfahren für die Restgebrauchsdauer von Spulen nach Anspruch 1, wobei der erste Schritt des Schätzens der Durchschlagspannung der Spule enthält: Anlegen einer alternativen Spannung an einen Leiter der Spule, Messen eines inneren Elektrodenpotenzials an einer Außenfläche einer Isolierschicht auf einer inneren Elektrode, Bestimmen eines Verhältnisses zwischen benachbarten inneren Elektrodenpotenzialen, und Berechnen einer Durchschlagspannung, die dem bestimmten Verhältnis entspricht, auf der Basis eines zuvor erstellten Kennliniendiagramms eines Durchschlagspannungsverhältnisses zwischen benachbarten inneren Elektrodenpotenzialen.

**4.** Vorhersageverfahren für die Restgebrauchsdauer von Spulen nach Anspruch 1, wobei der erste Schritt des Schätzens der Durchschlagspannung der Spule enthält: Anbringen einer Messelektrode an einer Außenfläche einer Isolierschicht, die die innere Elektrode und eine Außenfläche einer Isolierschicht in einen Abschnitt, der von der inneren Elektrode entfernt liegt, enthält, Messen dielektrischer Eigenschaften zwischen der Messelektrode und der inneren Elektrode und zwischen der Messelektrode und einem Leiter in dem Abschnitt, der von der inneren Elektrode entfernt liegt, und Berechnen einer Durchschlagspannung, die den bestimmten dielektrischen Eigenschaften entspricht, auf der Basis eines zuvor erstellten Kennliniendiagramms zwischen der Durchschlagspannung und den dielektrischen Eigenschaften.

5. Vorhersageverfahren für die Restgebrauchsdauer von Spulen nach Anspruch 1, wobei der erste Schritt des Schätzens der Durchschlagspannung der Spule enthält: Anbringen einer Messelektrode an einer Außenfläche einer Isolierschicht, die die innere Elektrode und eine Außenfläche einer Isolierschicht in einen Abschnitt, der von der inneren Elektrode entfernt liegt, enthält, Messen dielektrischer Eigenschaften zwischen der Messelektrode und der inneren Elektrode und zwischen der Messelektrode und einem Leiter in dem Abschnitt, der von der inneren Elektrode entfernt liegt, Bestimmen eines Verhältnisses von dielektrischen Eigenschaften bei zwei Frequenzen, und Berechnen einer Durchschlagspannung, die dem bestimmten Verhältnis entspricht, auf der Basis eines zuvor erstellten Diagramms, das eine Änderungsrate einer Durchschlagspannung als Funktion der dielektrischen Eigenschaften mit der Frequenz zeigt.

6. Vorhersageverfahren für die Restgebrauchsdauer von Spulen nach Anspruch 1, wobei der erste Schritt des Schätzens der Durchschlagspannung der Spule enthält: Bestimmen eines zweckmäßigen Durchschlagspannungswertes, wenn beim Berechnen der Durchschlagspannung zwei Durchschlagspannungswerte für ein einzelnes inneres Elektrodenpotenzial erhalten werden, auf der Basis eines Kennliniendiagramms zwischen einer Durchschlagspannung und einem inneren Elektrodenpotenzial oder eines Kennliniendiagramms des Durchschlagspannungsverhältnisses zwischen innerem Elektrodenpotenzial und Anfangswert oder eines Kennliniendiagramms des Durchschlagspannungsverhältnisses zwischen benachbarten inneren Elektrodenpotenzialen, in Kombination mit einem Kennliniendiagramm zwischen Durchschlagspannung und dielektrischen Eigenschaften.

7. Vorhersageverfahren für die Restgebrauchsdauer von Spulen nach Anspruch 1, wobei der erste Schritt des Schätzens der Durchschlagspannung der Spule enthält: Bestimmen eines zweckmäßigen Durchschlagspannungswertes, wenn beim Berechnen der Durchschlagspannung zwei Durchschlagspannungswerte für ein einzelnes inneres Elektrodenpotenzial erhalten werden, auf der Basis eines Kennliniendiagramms zwischen einer Durchschlagspannung und einem inneren Elektrodenpotenzial oder eines Kennliniendiagramms des Durchschlagspannungsverhältnisses zwischen innerem Elektrodenpotenzial und Anfangswert oder eines Kennliniendiagramms des Durchschlagspannungsverhältnisses zwischen benachbarten inneren Elektrodenpotenzialen, auf der Basis einer Änderung eines zuvor gemessenen Potenzials.

8. Vorhersageverfahren für die Restgebrauchsdauer von Spulen nach Anspruch 1, wobei der erste Schritt des Schätzens der Durchschlagspannung der Spule enthält: Erstellen eines Kennliniendiagramms zwischen einer Durchschlagspannung und einem inneren Elektrodenpotenzial, eines Kennliniendiagramms des Durchschlagspannungsverhältnisses zwischen innerem Elektrodenpotenzial und Anfangswert, eines Kennliniendiagramms des Durchschlagspannungsverhältnisses zwischen benachbarten inneren Elektrodenpotenzialen, eines Kennliniendiagramms zwischen Durchschlagspannung und benachbarten Elektroden, und einen Diagramms einer Änderungsrate einer Durchschlagspannung als Funktion der dielektrischen Eigenschaften mit der Frequenz zeigt, auf der Basis eines inneren Elektrodenpotenzials, das an einer Außenfläche einer Isolierschicht auf einer inneren Elektrode unmittelbar vor einem Dielektrizitätstest für mehrere Spulen, bei denen Kühlwasser ausläuft, gemessen wurde, dielektrischer Eigenschaften zwischen einer Messelektrode, die auf der Außenfläche der Isolierschicht angeordnet ist, und einem Leiter und zwischen der Messelektrode und der inneren Elektrode, und einer Durchschlagspannung, die nach den Messungen gemessen wurde, und Schätzen einer Durchschlagspannung auf der Basis der erzeugten Diagramme bei anschließenden Messungen.

9. Vorhersagevorrichtung für die Restgebrauchsdauer, die dafür ausgelegt ist, das Verfahren nach Anspruch 1 auszuführen, umfassend:

ein kontaktloses Flächenelektrometer zum Messen eines Potenzials einer internen Elektrode, die in einer Isolierschicht, die eine Spule bedeckt, angeordnet ist, und
eine Dielektrizitätseigenschaften-Messvorrichtung zum Messen dielektrischer Eigenschaften zwischen mindestens einer der internen Elektrode und einem Leiter und einer Messelektrode, die an einer Außenfläche der Isolierschicht der Spule angebracht ist, um eine Restgebrauchsdauer auf der Grundlage einer Durchschlagspannung, die auf der Basis des gemessenen Potenzials geschätzt wurde, vorherzusagen,
wobei beim Anbringen der Messelektrode an der Isolierschicht eine Sonde des kontaktlosen Flächenelektrometers entlang der Spule bewegt wird und die Messelektrode an der Oberfläche der Isolierschicht an einer Position angebracht ist, wo ein stabiles Obertlächenpotenzial festgestellt wird.

**Revendications**

1. Procédé de prédiction de la durée de vie restante d'une bobine comprenant :

   une première étape qui consiste à vérifier si de l'eau de refroidissement qui provient d'un conducteur fuit ou non vers une couche isolante, et à exécuter une mesure nécessaire pour estimer une tension de rupture d'une bobine plusieurs fois au fil du temps si l'eau de refroidissement du conducteur fuit vers la couche isolante de façon à estimer une tension de rupture d'une bobine, et à estimer une tension de rupture d'une bobine à chaque fois que la mesure est exécutée, l'étape d'estimation comprenant en outre l'application d'une tension alternative à un conducteur de la bobine, la mesure d'un potentiel d'électrode interne au niveau d'une surface externe d'une couche isolante sur une électrode interne, et le calcul d'une tension de rupture correspondant au potentiel d'électrode interne mesuré sur la base d'un diagramme caractéristique de tension de rupture/potentiel d'électrode interne préalablement créé ;
   une seconde étape qui consiste à dessiner et à extrapoler une courbe qui représente un changement de tension de rupture au fil du temps afin de prédire une future tendance à la diminution de la tension de rupture ; et
   une troisième étape qui consiste à déterminer une période nécessaire à la tension de rupture pour chuter jusqu'à une tension nécessaire pour faire fonctionner la bobine sur la base de la courbe qui représente le changement au fil du temps.

2. Procédé de prédiction de la durée de vie restante d'une bobine selon la revendication 1, dans lequel la première étape d'estimation de la tension de rupture de la bobine comprend l'application d'une tension alternative à un conducteur de la bobine, la mesure d'un potentiel d'électrode interne au niveau d'une surface externe d'une couche isolante sur une électrode interne, la détermination d'un rapport entre le potentiel d'électrode interne mesuré et une valeur initiale du potentiel d'électrode interne ou d'un potentiel d'électrode interne de la bobine déterminé comme ne souffrant pas d'une fuite d'eau de refroidissement du conducteur dans la couche isolante, et le calcul d'une tension de rupture qui correspond au rapport déterminé sur la base d'un diagramme caractéristique de rapport de tension entre le potentiel d'électrode interne et la valeur initiale préalablement créé.

3. Procédé de prédiction de la durée de vie restante d'une bobine selon la revendication 1, dans lequel la première étape d'estimation de la tension de rupture de la bobine comprend l'application d'une tension alternative à un conducteur de la bobine, la mesure d'un potentiel d'électrode interne au niveau d'une surface externe d'une couche isolante sur une électrode interne, la détermination d'un rapport entre les potentiels d'électrodes internes adjacents, et le calcul d'une tension de rupture qui correspond au rapport déterminé sur la base d'un diagramme caractéristique de rapport de tension entre les potentiels d'électrodes internes adjacents préalablement créé.

4. Procédé de prédiction de la durée de vie restante d'une bobine selon la revendication 1, dans lequel la première étape d'estimation de la tension de rupture de la bobine comprend le raccordement d'une électrode de mesure à une surface externe d'une couche isolante qui comprend l'électrode interne et une surface externe d'une couche isolante dans une partie séparée de l'électrode interne, la mesure de caractéristiques diélectriques entre l'électrode de mesure et l'électrode interne et entre l'électrode de mesure et un conducteur dans la partie séparée de l'électrode interne, et le calcul d'une tension de rupture qui correspond aux caractéristiques diélectriques déterminées sur la base d'un diagramme caractéristique de tension de rupture/caractéristique diélectrique préalablement créé.

5. Procédé de prédiction de la durée de vie restante d'une bobine selon la revendication 1, dans lequel la première étape d'estimation de la tension de rupture de la bobine comprend le raccordement d'une électrode de mesure à une surface externe d'une couche isolante qui comprend l'électrode interne et à une surface externe d'une couche isolante dans une partie séparée de l'électrode interne, la mesure de caractéristiques diélectriques entre l'électrode de mesure et l'électrode interne et entre l'électrode de mesure et un conducteur dans la partie séparée de l'électrode interne, la détermination d'un rapport de caractéristiques diélectriques à deux fréquences, et le calcul d'une tension de rupture qui correspond au rapport déterminé sur la base d'un diagramme préalablement créé qui indique une vitesse de changement du rapport tension de rupture/caractéristique diélectrique en fonction de la fréquence.

6. Procédé de prédiction de la durée de vie restante d'une bobine selon la revendication 1, dans lequel la première étape d'estimation de la tension de rupture de la bobine comprend la détermination d'une valeur de tension de rupture appropriée si deux valeurs de tension de rupture sont obtenues pour un potentiel d'électrode interne lors du calcul de la tension de rupture sur la base de l'un d'un diagramme caractéristique de tension de rupture/potentiel d'électrode interne, d'un diagramme caractéristique de rapport de tension entre le potentiel d'électrode interne et une valeur initiale, et d'un diagramme caractéristique de rapport de tension de rupture entre des potentiels d'électrodes internes adjacents, en combinaison avec un diagramme caractéristique de tension de rupture/caractéristique diélectrique.

7. Procédé de prédiction de la durée de vie restante d'une bobine selon la revendication 1, dans lequel la première étape d'estimation de la tension de rupture de la bobine comprend la détermination d'une valeur de tension de rupture appropriée si deux valeurs de tension de rupture sont obtenues pour un potentiel d'électrode interne lors du calcul de la tension de rupture sur la base de l'un d'un diagramme caractéristique de tension de rupture/potentiel d'électrode interne, d'un diagramme caractéristique de rapport de tension entre le potentiel d'électrode interne et une valeur initiale, et d'un diagramme caractéristique de rapport de tension de rupture entre les potentiels d'électrodes internes adjacents, sur la base d'un changement d'un potentiel préalablement mesuré.

8. Procédé de prédiction de la durée de vie restante d'une bobine selon la revendication 1, dans lequel la première étape d'estimation de la tension de rupture de la bobine comprend la création d'un diagramme caractéristique de tension de rupture/potentiel d'électrode interne, d'un diagramme caractéristique de rapport de tension de rupture entre le potentiel d'électrode interne et une valeur initiale, d'un diagramme caractéristique de rapport de tension de rupture entre les potentiels d'électrodes internes adjacents, d'un diagramme caractéristique de tension de rupture/électrodes adjacentes, et d'un diagramme de vitesse de changement du rapport tension de rupture/caractéristique diélectrique en fonction de la fréquence sur la base d'un potentiel d'électrode interne mesuré au niveau d'une surface externe d'une couche isolante sur une électrode interne juste avant un test diélectrique pour une pluralité de bobines qui souffrent d'une fuite d'eau de refroidissement, de caractéristiques diélectriques entre une électrode de mesure placée sur la surface externe de la couche isolante et un conducteur, et entre l'électrode de mesure et l'électrode interne, et d'une tension de rupture mesurée après les mesures ; et l'estimation d'une tension de rupture sur la base des diagrammes créés lors de mesures ultérieures.

9. Appareil de prédiction de la durée de vie restante d'une bobine adapté pour exécuter le procédé selon la revendication 1, comprenant :

un électromètre de surface de non-contact destiné à mesurer un potentiel d'une électrode interne prévue dans une couche isolante qui recouvre une bobine ; et
un appareil de mesure de caractéristiques diélectriques destiné à mesurer des caractéristiques diélectriques entre au moins l'un de l'électrode interne et d'un conducteur et d'une électrode de mesure reliée à une surface externe de la couche isolante de la bobine afin de prédire une durée de vie restante sur la base d'une tension de rupture estimée sur la base du potentiel mesuré,
dans lequel, lors du raccordement de l'électrode de mesure à la couche isolante, une sonde de l'électromètre de surface de non-contact est déplacée le long de la bobine, et l'électrode de mesure est reliée à la surface de la couche isolante à un emplacement auquel un potentiel de surface stable est détecté.

STEP1

STEP2

STEP3

OPERATION CONDITION
{ ·TEMPERATURE
  ·VOLTAGE }

RESIDUAL
LIFE

# FIG. 1

INSULATION BREAKDOWN VOLTAGE (RATIO) (%)

120

100

80

60

40

20

0

A

L

Eo

B

0 10 20

RESIDUAL
LIFE

OPERATING PERIOD (YEAR)

# FIG. 2

**FIG. 3**

**FIG. 4**

24

14a
14b
14g

18aw ⎫
18ad ⎬ 13a

13b
13c

3

# FIG. 5

Vg=0

14g
Cc
14b
Cb
14a
Ca
Ra

13c
Vb
13b
Va
13a

12

# FIG. 6

FIG. 7

FIG. 8

26

FIG. 9

FIG. 10

## FIG. 11

## FIG. 12

F I G. 13

F I G. 14

FIG. 15

FIG. 16

F I G. 17

F I G. 18

FIG. 19

FIG. 20

FIG. 21

FIG. 22

F I G. 23

F I G. 24

FIG. 25

FIG. 26

FIG. 27

FIG. 28

24 (24a, 24b, 24s)

30

40

39

38

37

XXX

XXX

# FIG. 29

24 (24a, 24b, 24s)

30

40

39

38

37

# FIG. 30

24(24a, 24b, 24s)

30

40

39

38

41

37

XXXII

XXXII

# FIG. 31

24(24a, 24b, 24s)

30

40

39

41

37

# FIG. 32

FIG. 33

FIG. 34

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9331656 A
- JP 9051658 A
- JP 10177053 A
- JP 2000126293 A
- JP 9093873 A

**Non-patent literature cited in the description**

- **INOUE Y et al.** Technology for detecting wet bars in water-cooled stator windings of turbine generators. Electric Machines and Drives Conference, Inc, 2003